# EUROPEAN PATENT APPLICATION

(11) **EP 4 546 991 A1**
(43) Date of publication of application: **30.04.2025**
(21) Application number: 24206892.2
(22) Date of filing: 16.10.2024
(51) Int. Cl.: H10K 59/122, H10K 59/80, H10K 59/84

(54) **DISPLAY DEVICE AND METHOD OF FABRICATING THE SAME**

(30) Priority: 25.10.2023 KR 20230143448
(71) Applicant: Samsung Display Co., Ltd., Gyeonggi-do 17113 (KR)
(72) Inventor: SUNG, Woo Yong, Yongin-si, Gyeonggi-do (KR); SONG, Seung Yong, Yongin-si, Gyeonggi-do (KR); YANG, Hee Jun, Yongin-si, Gyeonggi-Do (KR); LEE, Jeong Seok, Yongin-si, Gyeonggi-do (KR)
(74) Representative: Gulde & Partner

(57) **Abstract**

A display device includes a substrate including an emission area including first and second emission portions, and a non-emission area between the first and second emission portions; a first light-emitting member including a first display element on the first emission portion of the substrate; a first thin-film encapsulation layer on the first light-emitting member; and a second light-emitting member on the first thin-film encapsulation layer and including a second display element overlapping the second emission portion, wherein the first light-emitting member includes a first pixel-defining layer defining a first opening; and a bank member on the first pixel-defining layer and including a first bank layer and a second bank layer, the second display element overlaps the first pixel-defining layer and the bank member in a direction perpendicular to the substrate, and the second display element is in contact with the second bank layer in a direction toward the substrate.

## Description

### BACKGROUND

### 1. Technical Field

Embodiments relate to a display device and a method of fabricating the display device.

### 2. Description of the Related Art

As the information-oriented society evolves, various demands for display devices are ever increasing. For example, display devices are being used by a variety of electric devices such as smart phones, digital cameras, laptop computers, navigation devices, and smart televisions. Display devices may be flat-panel display devices such as a liquid-crystal display device, a field emission display device, and an organic light-emitting display device. Among such flat panel display devices, a light-emitting display device includes a light-emitting element that emits light on its own, so that each of the pixels of the display panel may emit light by themselves. Accordingly, a light-emitting display device may display images without a backlight unit that supplies light to the display panel.

Recently, as a variety of electric devices have developed, the demand for high-aperture ratio and high-resolution display devices is increasing. Since high pixel density is required for display devices having a high aperture ratio and a high resolution, a display device for achieving it, and a method for fabricating such a display device may be required.

### SUMMARY

Embodiments provide a display device having a high aperture ratio and a high resolution, and a method of fabricating the display device.

It should be noted that objects of the disclosure are not limited to the above-mentioned object; and other objects of the disclosure will be apparent to those skilled in the art from the following descriptions.

An embodiment of a display device may include a substrate including an emission area including a first emission portion and a second emission portion, and a non-emission area disposed between the first emission portion and the second emission portion; a first light-emitting member including a first display element disposed on the first emission portion of the substrate; a first thin-film encapsulation layer disposed on the first light-emitting member; and a second light-emitting member disposed on the first thin-film encapsulation layer and including a second display element overlapping the second emission portion, wherein the first light-emitting member includes a first pixel-defining layer defining a first opening; and a bank member disposed on the first pixel-defining layer and including a first bank layer and a second bank layer, wherein the second display element overlaps the first pixel-defining layer and the bank member in a direction perpendicular to an upper surface of the substrate, and wherein the second display element may be in contact with the second bank layer in a direction toward the substrate.

The first display element may include a first electrode a first display emissive layer disposed on the first electrode; and a second electrode disposed on the first display emissive layer, wherein the first display emissive layer and the second electrode are in contact with a side surface of the first bank layer that faces the first emission portion, and wherein the second electrode may be electrically connected to the first bank layer.

The second bank layer may include a tip portion that protrudes toward the first emission portion from the side surface of the first bank layer, and wherein the side surface of the first bank layer and the tip portion of the second bank layer form an undercut portion.

A first pattern layer may be disposed between the first electrode and the first pixel-defining layer in the direction perpendicular to the upper surface of the substrate in the non-emission area, and wherein the first pattern layer may be in contact with the first display emissive layer.

The first opening may define the first emission portion.

The first thin-film encapsulation layer may include a first encapsulation layer in contact with the first display element and the bank member; a second encapsulation layer including an organic material disposed on the first encapsulation layer; and a third encapsulation layer including an inorganic material disposed on the second encapsulation layer, and wherein the second encapsulation layer may be completely surrounded by the first encapsulation layer and the third encapsulation layer in the first emission portion.

The second encapsulation layer may not overlap the second emission portion.

The second light-emitting member may further include a second pixel-defining layer overlapping the first emission portion and defining a second opening, and wherein the second pixel-defining layer may overlap the first display element in the direction perpendicular to the upper surface of the substrate.

The second display element may include a third electrode; a second display emissive layer disposed on the third electrode; and a common electrode disposed on the second display emissive layer and the second pixel-defining layer.

The third electrode may be in contact with the second bank layer in the direction toward the substrate, and wherein the third electrode may be electrically connected to the second bank layer, the first bank layer and the first electrode.

A second pattern layer may be disposed between the third electrode and the second pixel-defining layer in the direction perpendicular to the upper surface of the substrate in the non-emission area, and wherein the second pattern layer may be in contact with the second display emissive layer.

The second opening may define the second emission portion.

The first pixel-defining layer may have a mesh pattern that completely surrounds the first emission portion in plan view, and wherein the second pixel-defining layer may have a mesh pattern that completely surrounds the second emission portion in plan view.

The emission area may be larger than the non-emission area in plan view.

An embodiment of a display device may include a substrate including a first emission area including a first emission portion and a second emission portion, and a second emission area spaced apart from the second emission portion with the first emission portion disposed between the second emission area and the second emission portion; a first light-emitting member disposed on the substrate and including a first light-emitting element overlapping the first emission portion, a second light-emitting element overlapping the second emission area, and a bank member overlapping the second emission portion; a first encapsulation layer disposed on the first light-emitting member; and a second light-emitting member disposed on the first encapsulation layer and including a third light-emitting element overlapping the second emission portion, wherein the bank member includes a first portion in contact with the first light-emitting element, a second portion in contact with the third light-emitting element, and a third portion in contact with the second light-emitting element, and wherein the first portion, the second portion and the third portion are spaced apart from one another with the first encapsulation layer disposed between the first portion, the second portion and the third portion.

The first encapsulation layer may include a first inorganic layer surrounding the first portion; and a second inorganic layer surrounding the third portion, and wherein the first inorganic layer and the second inorganic layer may be spaced apart from each other in a direction parallel to an upper surface of the substrate with the second portion disposed between the first inorganic layer and the second inorganic layer.

The first light-emitting member may further include a first pixel-defining layer disposed between the substrate and the bank member, wherein the first pixel-defining layer includes a first sub-portion in contact with the first portion and a second sub-portion in contact with the third portion, and wherein the first sub-portion and the second sub-portion may be spaced apart from each other with the second portion disposed between the first sub-portion and the second sub-portion.

The second light-emitting element may include an anode electrode, and wherein the second portion may be in contact with the anode electrode in a direction toward the substrate.

An embodiment of a method of fabricating a display device, the method including preparing a substrate comprising an emission area comprising a first emission portion and a second emission portion, and a non-emission area disposed between the first emission portion and the second emission portion; forming a first electrode disposed on the first emission portion of the substrate and a sacrificial layer disposed on the first electrode, and forming a first pixel-defining material layer that covers the sacrificial layer and exposes a part of the first electrode; forming a first bank material layer covering the first electrode and the first pixel-defining material layer, and a second bank material layer disposed on the first bank material layer, and then removing the first bank material layer and the second bank material layer and a part of the first pixel-defining material layer by an etching process to form first and second holes overlapping the first electrode and spaced apart from each other; partially etching an inside of the first hole by an etching process to form a first bank layer and a second bank layer having a tip portion protruding from the first bank layer toward the first emission portion, and forming a first pixel-defining layer defining a first opening; forming a first display emissive layer and a second electrode disposed on the first electrode such that the first display emissive layer and the second electrode may be in contact with a side surface of the first bank layer in the first emission portion, and forming a first thin-film encapsulation layer covering the second electrode, the first bank layer and the second bank layer; removing a part of the first thin-film encapsulation layer by an etching process in the second emission portion to expose a part of the second bank layer in the second emission portion; forming a third electrode disposed on the second bank layer and the first thin-film encapsulation layer and a sacrificial layer disposed on the third electrode in the second emission portion, and a second pixel-defining layer cover a part of the sacrificial layer and defining a second opening in the first emission portion; removing the sacrificial layer disposed on the third electrode by an etching process using the second pixel-defining layer as a mask, forming a second display emissive layer disposed on the third electrode, and then a common electrode entirely covering the second display emissive layer and the second pixel-defining layer; and forming a second thin-film encapsulation layer disposed on the common electrode, wherein the forming of the third electrode may include disposing the third electrode to contact the second bank layer.

The first pixel-defining layer may overlap the second display emissive layer in a direction perpendicular to the upper surface of the substrate, and the second pixel-defining layer overlaps the first display emissive layer in the direction perpendicular to the upper surface of the substrate.

A display device according to an embodiment may include a first light-emitting member and a second light-emitting member that are vertically stacked. A first pixel-defining layer included in the first light-emitting member may define a first opening, and a second pixel-defining layer included in the second light-emitting member may define a second opening. The light emitting from the first opening and the light emitting from the second opening may have the same color.

The claimed display device enables to enlarge the emission areas while reducing the non-emission area. The display device according to an embodiment may be designed such that the first opening and the second opening may not overlap each other in a direction perpendicular to an upper surface of the substrate. The display device according to an embodiment may have a high aperture ratio and a high resolution.

It should be noted that effects of the disclosure are not limited to those described above and other effects of the disclosure will be apparent to those skilled in the art from the following descriptions.

### BRIEF DESCRIPTION OF THE DRAWINGS

The above and other aspects and features of the disclosure will become more apparent by describing in detail embodiments thereof with reference to the attached drawings, in which:
FIG. 1 is a schematic perspective view showing an electric device according to an embodiment.
FIG. 2 is a schematic perspective view showing a display device included in an electric device according to an embodiment.
FIG. 3 is a schematic cross-sectional view of the display device of FIG. 2.
FIG. 4 is a schematic plan view of the display layer of FIG. 3.
FIG. 5 is a schematic plan view showing a layout of emission areas in the display area of FIG. 4.
FIG. 6 is a schematic cross-sectional view of the display area, taken along line X1 - X1' of FIG. 5.
FIG. 7 is an enlarged schematic cross-sectional view of the first emission portion of the first emission area of FIG. 6.
FIG. 8 is an enlarged schematic cross-sectional view of the second emission portion of the first emission area of FIG. 6.
FIG. 9 is a schematic plan view showing a layout of the first pixel-defining layer and the second pixel-defining layer in FIG. 6.
FIGS. 10, 11, 12, 13, 14, 15, 16, 17, 18, 19, 20, 21, 22, and 23 are schematic cross-sectional views for illustrating a method of fabricating the display element layer in FIG. 6.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" may encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate members. As such, variations from the shapes of the illustrations as a result, for example, of manufacturing techniques and/or tolerances, are to be expected. Thus, embodiments disclosed herein should not be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Hereinafter, embodiments will be described in detail with reference to the accompanying drawings.

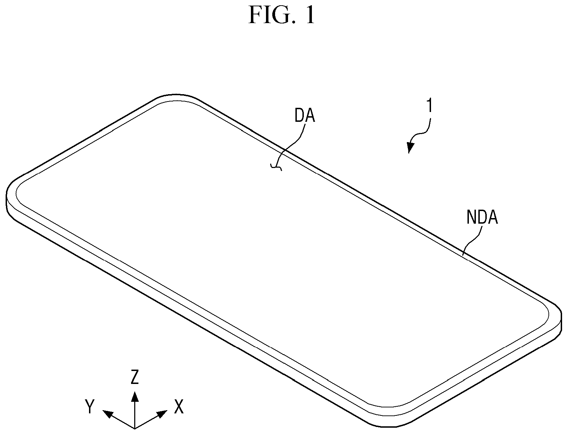

FIG. 1 is a schematic perspective view of an electric device 1 according to an embodiment.

Referring to FIG. 1, an electric device 1 may display a moving image or a still image. The electric device 1 may include electronic devices that provides a display screen. For example, the electric device 1 may include a television set, a laptop computer, a monitor, an electronic billboard, the Internet of Things (IoT) devices, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console and a digital camera, a camcorder, etc.

In FIG. 1, a first direction (e.g., X-axis direction), a second direction (e.g., Y-axis direction) and a third direction (e.g., Z-axis direction) are defined. The first direction (e.g., X-axis direction) and the second direction (e.g., Y-axis direction) may be perpendicular to each other, the first direction (e.g., X-axis direction) and the third direction (e.g., Z-axis direction) may be perpendicular to each other, and the second direction (e.g., Y-axis direction) and the third direction (e.g., Z-axis direction) may be perpendicular to each other. The first direction (e.g., X-axis direction) may refer to the horizontal direction in the drawings, the second direction (e.g., Y-axis direction) may refer to the vertical direction in the drawings, and the third direction (e.g., Z-axis direction) may refer to the up- and-down direction, i.e., the thickness direction in the drawings. As used herein, a direction may refer to the direction indicated by the arrow as well as the opposite direction, unless specifically stated otherwise. If it is necessary to discern between such two opposite directions, one of the two directions may be referred to as "a side in the direction," while the other direction may be referred to as "the opposite side in the direction." In FIG. 1, the side indicated by an arrow indicative of a direction is referred to as a side in the direction, while the opposite side is referred to as the opposite side in the direction.

In the following description of the surfaces of the electric device 1 or the elements of the electric device 1, the surface facing a side where images are displayed, i.e., the side indicated by the arrow in the third direction (e.g., Z-axis direction) will be referred to as the upper surface, while the opposite surface will be referred to as the lower surface, for convenience of illustration. It should be understood, however, that embodiments are not limited thereto. The surfaces and the opposite surface of each of the elements may be referred to as a front surface and a rear surface, respectively, or may be referred to as a first surface and a second surface, respectively. In the description of relative positions of the elements of the electric device 1, a side in the third direction (e.g., Z-axis direction) may be referred to as the upper side while the opposite side in the third direction (e.g., Z-axis direction) may be referred to as the lower side.

The shape of the electric device 1 may be modified in a variety of ways. For example, the electric device 1 may have shapes such as a rectangle with longer lateral sides, a rectangle with longer vertical sides, a square, a quadrangle with rounded corners (e.g., vertices), other polygons, a circle, etc.

The electric device 1 may include the display area DA and a non-display area NDA. In the display area DA, images may be displayed. In the non-display area NDA, images may not be displayed. The display area DA may be referred to as an active area, while the non-display area NDA may also be referred to as an inactive area. The display area DA may generally occupy the center of the electric device 1.

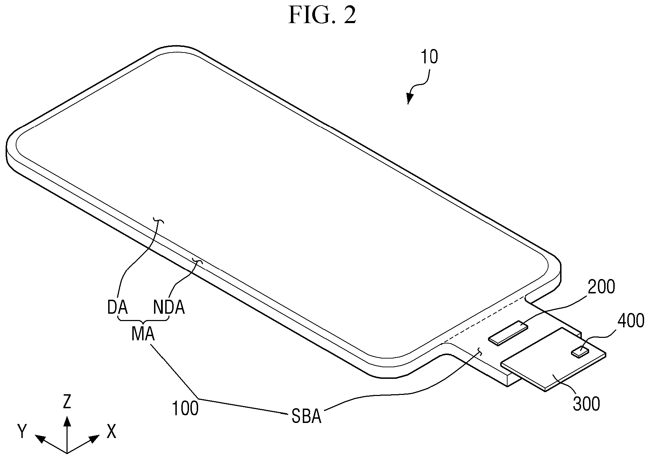

FIG. 2 is a schematic perspective view showing a display device 10 included in the electric device 1 according to an embodiment.

Referring to FIG. 2, the electric device 1 according to an embodiment may include the display device 10. The display device 10 may provide a display screen where images are displayed in the electric device 1. Examples of the display device 10 may include an inorganic light-emitting diode display device, an organic light-emitting display device, a quantum-dot light-emitting display device, a plasma display device, a field emission display device, etc. In the following description, an organic light-emitting diode display device may be used as an example of the display device, but embodiments are not limited thereto. Any other display device may be used as long as the technical idea of the disclosure may be equally applied.

The display device 10 may have a shape similar to that of the electric device 1 in plan view (or when viewed from the top). For example, the display device 10 may have a shape similar to a rectangle having shorter sides in the first direction (e.g., X-axis direction) and longer sides in the second direction (e.g., Y-axis direction). The corners where the shorter sides in the first direction (e.g., X-axis direction) meet the longer sides in the second direction (e.g., Y-axis direction) may be rounded with a certain curvature. It should be understood, however, that embodiments are not limited thereto. The corners may be formed at a right angle. The shape of the display device 10 in plan view (or when viewed from the top) is not limited to a quadrangular shape, but may be formed in a shape similar to other polygonal shapes, a circular shape, or an elliptical shape.

The display device 10 may include a display panel 100, a display driver 200, a circuit board 300 and a touch driver 400.

The display panel 100 may include a main area MA and a subsidiary area SBA. The main area MA may include the display area DA including pixels for displaying images, and the non-display area NDA disposed around the display area DA.

The display area DA may emit light from emission areas or opening areas to be described later. For example, the display area DA may include a pixel circuit including switching elements, a pixel-defining layer that defines the emission areas or the opening areas, and a self-light-emitting element.

The non-display area NDA may be disposed on the outer side of the display area DA. The non-display area NDA may be defined as the edge portion of the main area MA of the display panel 100. The non-display area NDA may include a line driver that supplies signals to the display area DA, and lines connecting the display driver 200 with the display area DA.

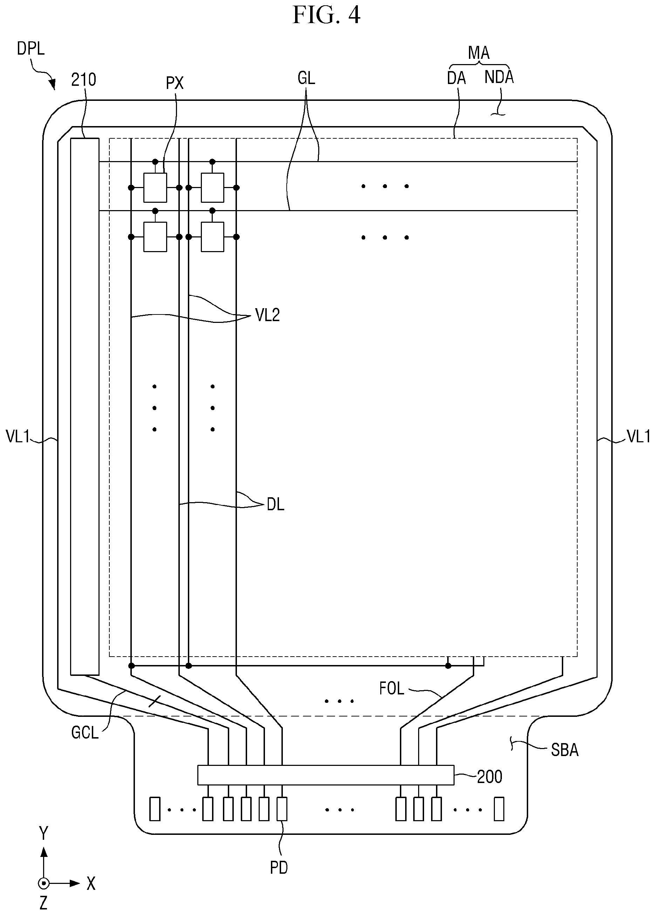

The subsidiary area SBA may be extended from a side of the main area MA. The subsidiary area SUB may include a flexible material that is bendable, foldable, or rollable. For example, in case that the subsidiary area SBA is bent, the subsidiary area SBA may overlap the main area MA in the thickness direction (e.g., the third direction or Z-axis direction). The subsidiary area SBA may include display pads PD (see FIG. 4) connected to the display driver 200 and the circuit board 300. According to another embodiment, the subsidiary area SBA may be eliminated, and the display driver 200 and the display pads may be disposed in the non-display area NDA.

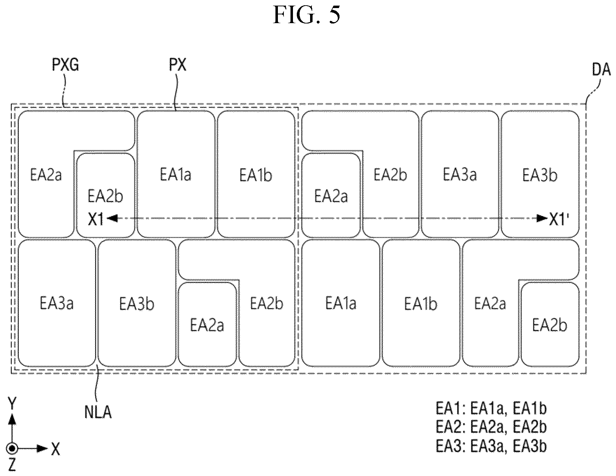

The display driver 200 may output signals and voltages for driving the display panel 100. The display driver 200 may supply data voltages to data lines DL (see FIG. 4), which will be described later. For example, the display driver 200 may supply a supply voltage to voltage lines VL1 and VL2 (see FIG. 4) and a gate control signal to the gate driver 210 (see FIG. 5). The display driver 200 may be implemented as an integrated circuit (IC) and may be attached on the display panel 100 by a chip-on-glass (COG) technique, a chip-on-plastic (COP) technique, or ultrasonic bonding. For example, the display driver 200 may be disposed in the subsidiary area SBA and may overlap the main area MA in the thickness direction as the subsidiary area SBA is bent. For another example, the display driver 200 may be mounted on the circuit board 300.

The circuit board 300 may be attached on the display pads of the display panel 100 using an anisotropic conductive film (ACF). The circuit board 300 may be electrically connected to the display pads. The circuit board 300 may be a flexible printed circuit board (FPCB), a printed circuit board (PCB), or a flexible film such as a chip-on-film (COF).

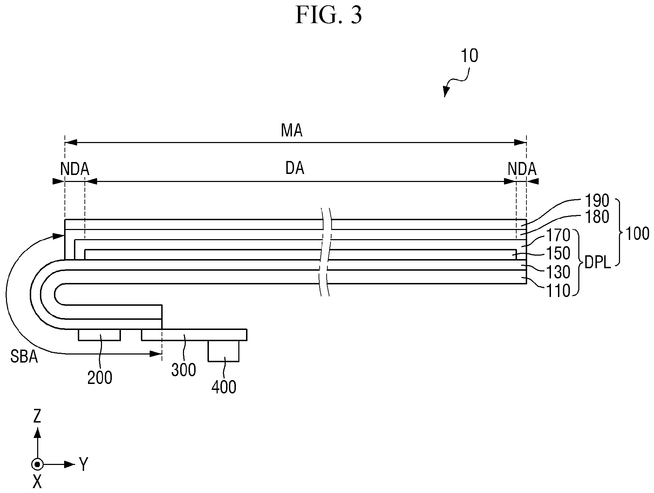

The touch driver 400 may be mounted on the circuit board 300. The touch driver 400 may be connected to a touch sensor layer 180 (see FIG. 3) of the display panel 100.

FIG. 3 is a schematic cross-sectional view of the display device 10 of FIG. 2.

Referring to FIG. 3, the display panel 100 may include a display layer DPL, a touch sensor layer 180, and a color filter layer 190. The display layer DPL may include a substrate 110, a thin-film transistor layer 130, a display element layer 150, a thin-film encapsulation layer 170.

The substrate 110 may be a base substrate or a base member. The substrate 110 may be a flexible substrate that is bendable, foldable, or rollable. For example, the substrate 110 may include a polymer resin such as polyimide (PI). However, embodiments are not limited thereto. According to another embodiment, the substrate 110 may include a glass material or a metal material.

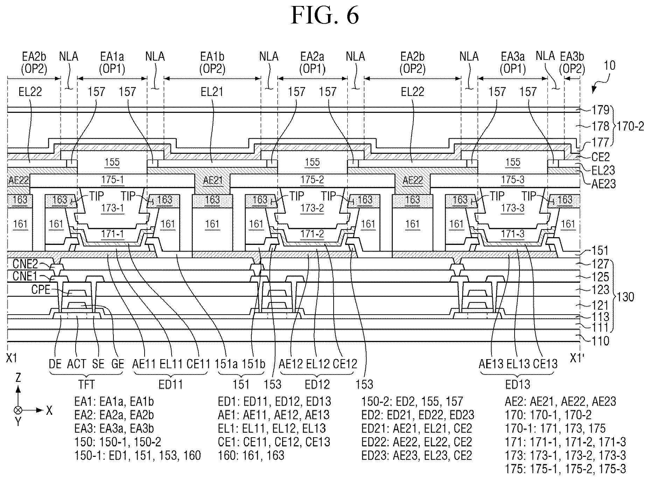

The thin-film transistor layer 130 may be disposed on the substrate 110. The thin-film transistor layer 130 may be disposed in the display area DA, the non-display area NDA and the subsidiary area SBA. The thin-film transistor layer 130 may include thin-film transistors TFT (see FIG. 6) forming pixels PX (see FIG. 4).

The display element layer 150 may be disposed on the thin-film transistor layer 130. The display element layer 150 may be disposed in the display area DA. The display element layer 150 may include display elements ED1 and ED2 (see FIG. 6). For example, the self-light-emitting element according to an embodiment may include at least one of: an organic light-emitting diode including an organic emissive layer, a quantum-dot light-emitting diode (quantum LED) including a quantum-dot emissive layer, an inorganic light-emitting diode (inorganic LED) including an inorganic semiconductor, and a micro light-emitting diode (micro LED). However, embodiments are not limited thereto.

The thin-film encapsulation layer 170 may be disposed on the display element layer 150. The thin-film encapsulation layer 170 may overlap the display area DA and the non-display area NDA. The thin-film encapsulation layer 170 may cover the upper and side surfaces of the display element layer 150, and may protect the display element layer 150 from outside oxygen and moisture. The thin-film encapsulation layer 170 may include at least one inorganic film and at least one organic film for encapsulating the display element layer 150.

The touch sensor layer 180 may be disposed on the thin-film encapsulation layer 170. The touch sensor layer 180 may overlap the display area DA and the non-display area NDA. The touch sensor layer 180 may sense a user's touch by mutual capacitance sensing or self-capacitance sensing.

The color filter layer 190 may be disposed on the touch sensor layer 180. The color filter layer 190 may overlap the display area DA and the non-display area NDA. The color filter layer 190 may absorb some of lights introduced from the outside of the display device 10 to reduce the reflection of external light. Accordingly, the color filter layer 190 may prevent distortion of colors due to the reflection of external light.

Since the color filter layer 190 is disposed (e.g., directly disposed) on the touch sensor layer 180, the display device 10 may require no separate substrate for the color filter layer 190. Therefore, the thickness of the display device 10 may be relatively small. For example, the color filter layer 190 may be eliminated in some implementations.

As shown in FIG. 3, a portion of the display layer DPL overlapping the subsidiary area SBA may be bent. In case that a portion of the display layer DPL is bent, the display driver 200, the circuit board 300 and the touch driver 400 may overlap the main area MA in the third direction (e.g., Z-axis direction).

FIG. 4 is a schematic plan view schematically showing the display layer of FIG. 3.

Referring to FIG. 4, the display layer DPL according to an embodiment may include pixels PX overlapping the display area DA of the main area MA, gate lines GL, data lines DL, and second voltage lines VL2.

Each of the pixels PX may be defined as the minimum unit that outputs light. Each of the pixels PX may form respective first to third emission areas EA1, EA2 and EA3, which will be described later.

The gate lines GL may supply the gate signals received from the gate driver 210 to the pixels PX. The gate lines GL may be extended in the first direction (e.g., X-axis direction) and may be spaced apart from each other in the second direction (e.g., Y-axis direction) intersecting the first direction (e.g., X-axis direction).

The data lines DL may supply the data voltages received from the display driver 200 to the pixels PX. The data lines DL may be extended in the second direction (e.g., Y-axis direction) and may be spaced apart from each other in the first direction (e.g., X-axis direction).

The second voltage lines VL2 may apply the supply voltage received from the display driver 200 to the pixels PX. The supply voltage may be at least one of a driving voltage, an initialization voltage, and a reference voltage. The second voltage lines VL2 may be extended in the second direction (e.g., Y-axis direction) and may be spaced apart from each other in the first direction (e.g., X-axis direction).

The display layer DPL according to an embodiment may overlap the non-display area NDA of the main area MA and may include a first voltage line VL1, a gate driver 210, fan-out lines FOL, and a gate control line GCL.

The gate driver 210 may generate gate signals based on the gate control signal, and may sequentially supply the gate signals to the gate lines GL in a certain order.

The first voltage line VL1 may surround the display area DA and may be disposed in the non-display area NDA. The first voltage line VL1 may apply the supply voltage received from the display driver 200 to the pixels PX. For example, the first voltage line VL1 may be electrically connected to a variety of lines disposed in the display area DA.

The fan-out lines FOL may be extended from the display driver 200 to the display area DA. The fan-out lines FOL may supply the data voltage received from the display driver 200 to the data lines DL.

A gate control line GCL may be extended from the display driver 200 to the gate driver 210. The gate control line GCL may supply the gate control signal received from the display driver 200 to the gate driver 210. Although the gate driver 210 is disposed only in the non-display area NDA on the left side of the display area DA in the drawings, embodiments are not limited thereto. According to another embodiment, the display device 10 may include gate drivers 210 disposed on the left and right sides of the display area DA, respectively.

The display layer DPL according to an embodiment may overlap the subsidiary area SBA and may include the display driver 200 and display pads PD.

The display driver 200 may output signals and voltages for driving the pixels PX to the fan-out lines FOL. The display driver 200 may supply data voltages to the data lines DL through the fan-out lines FOL. Thus, the data voltages may be applied to the pixels PX, so that the luminance of the pixels PX may be controlled. For example, the display driver 200 may supply a gate control signal to the gate driver 210 through the gate control lines GCL.

The display pads DP may be connected to a graphic system through the circuit board 300. The display pads DP may be connected to the circuit board 300 to receive digital video data and may supply the digital video data to the display driver 200.

FIG. 5 is a schematic plan view showing a layout of emission areas in the display area of FIG. 4.

Referring to FIG. 5, the display area DA according to an embodiment may include the first to third emission areas EA1, EA2 and EA3 and a non-emission area NLA.

The non-emission area NLA may be disposed to surround the first to third emission areas EA1, EA2 and EA3. The non-emission area NLA may help prevent the lights emitted from the first to third emission areas EA1, EA2 and EA3 from being mixed.

The first to third emission areas EA1, EA2 and EA3 may emit red light, green light, and blue light, respectively. The colors of lights emitted from the first to third emission areas EA1, EA2 and EA3 may vary according to the types of a first display element ED1 (see FIG. 6) and a second display element ED2 (see FIG. 6), which will be described later.

According to an embodiment, the first emission area EA1 may include a first emission portion EA1a and a second emission portion EA1b. The first emission portion EA1a and the second emission portion EA1b may be spaced apart from each other with a non-emission area NLA interposed between the first emission portion EA1a and the second emission portion EA1b in plan view. The first emission portion EA1a and the second emission portion EA1b may be surrounded (e.g., completely surrounded) by non-emissive area NLA in plan view. The first emission portion EA1a and the second emission portion EA1b may emit lights of the same color. As an example, the first emission portion EA1a and the second emission portion EA1b may emit red light. Although the first emission portion EA1a and the second emission portion EA1b have the same size in the drawings, but embodiments are not limited thereto. For example, the size (or area) and shape of the first emission portion EA1a and the second emission portion EA1b may be adjusted as required.

According to an embodiment, the second emission area EA2 may include a first emission portion EA2a and a second emission portion EA2b. The first emission portion EA2a and the second emission portion EA2b may be spaced apart from each other with a non-emission area NLA interposed between the first emission portion EA2a and the second emission portion EA2b in plan view. The first emission portion EA2a and the second emission portion EA2b may be surrounded (e.g., completely surrounded) by non-emissive area NLA in plan view. The first emission portion EA2a and the second emission portion EA2b may emit lights of the same color. As an example, the first emission portion EA2a and the second emission portion EA2b may emit green light. Although the first emission portion EA2a is smaller than the second emission portion EA2b in the drawings, but embodiments are not limited thereto. For example, the size (or area) and shape of the first emission portion EA2a and the second emission portion EA2b may be adjusted as required.

According to an embodiment, the third emission area EA3 may include a first emission portion EA3a and a second emission portion EA3b. The first emission portion EA3a and the second emission portion EA3b may be spaced apart from each other with a non-emission area NLA interposed between the first emission portion EA3a and the second emission portion EA3b in plan view. The first emission portion EA3a and the second emission portion EA3b may be surrounded (e.g., completely surrounded) by non-emissive area NLA in plan view. The first emission portion EA3a and the second emission portion EA3b may emit lights of the same color. As an example, the first emission portion EA3a and the second emission portion EA3b may emit blue light. Although the first emission portion EA3a and the second emission portion EA3b have the same size in the drawings, but embodiments are not limited thereto. For example, the size (or area) and shape of the first emission portion EA3a and the second emission portion EA3b may be adjusted as required.

At least one first emission area EA1, at least two second emission areas EA2 and at least one third emission area EA3 arranged adjacent to each other may form a single pixel group PXG. A pixel group PXG may be the minimum unit that emits white light. However, the type and/or number of each of the first to third emission areas EA1, EA2 and EA3 forming a pixel group PXG may vary according to embodiments.

FIG. 6 is a schematic cross-sectional view of the display area DA, taken along line X1 - X1' of FIG. 5.

FIG. 6 is a schematic cross-sectional view of a part of the display device 10 in the display area DA, showing the cross sections of the substrate 110, the thin-film transistor layer 130, the display element layer 150, and the thin-film encapsulation layer 170. The substrate 110 has been described above with reference to FIG. 3; and, therefore, the redundant descriptions will be omitted for descriptive convenience.

Referring to FIG. 6, the thin-film transistor layer 130 may be disposed on the substrate 110. The thin-film transistor layer 130 may include a first buffer layer 111, a thin-film transistor TFT, a gate insulating layer 113, a first interlayer dielectric layer 121, a capacitor electrode CPE, a second interlayer dielectric layer 123, a first connection electrode CNE1, a first via layer 125, a second connection electrode CNE2, and a second via layer 127.

The first buffer layer 111 may be disposed on the substrate 110. The first buffer layer 111 may include an inorganic film capable of preventing permeation of air or moisture. For example, the first buffer layer 111 may include inorganic films stacked on one another alternately.

The thin-film transistor TFT may be disposed on the first buffer layer 111 and may form a pixel circuit connected to each of pixels. For example, the thin-film transistor TFT may be a driving transistor or a switching transistor of the pixel circuit. The thin-film transistor TFT may include an active layer ACT, a source electrode SE, a drain electrode DE and a gate electrode GE.

The active layer ACT may be disposed on the first buffer layer 111. The active layer ACT may overlap the gate electrode GE in the third direction (e.g., Z-axis direction) and may be insulated from the gate electrode GE by the gate insulating layer 113. The material of a part of the active layer ACT may be made conductive to form the source electrode SE and the drain electrode DE.

The gate electrode GE may be disposed on the gate insulating layer 113. The gate electrode GE may overlap the active layer ACT with the gate insulating layer 113 interposed between the gate electrode GE may overlap the active layer ACT.

The gate insulating layer 113 may be disposed over the active layer ACT. For example, the gate insulating layer 131 may cover the active layer ACT and the first buffer layer 111, and may insulate the active layer ACT from the gate electrode GE. The gate insulating layer 113 may include a contact hole through which the first connection electrode CNE1 passes.

The first interlayer dielectric layer 121 may cover the gate electrode GE and the gate insulating layer 113. The first interlayer dielectric layer 121 may include a contact hole through which the first connection electrode CNE1 passes. The contact hole of the first interlayer dielectric layer 121 may be connected to the contact hole of the gate insulating layer 113 and a contact hole of the second interlayer dielectric layer 123.

The capacitor electrode CPE may be disposed on the first interlayer dielectric layer 121. The capacitor electrode CPE may overlap the gate electrode GE in the third direction (e.g., Z-axis direction). The capacitor electrode CPE and the gate electrode GE may form a capacitance.

The second interlayer dielectric layer 123 may cover the capacitor electrode CPE and the first interlayer dielectric layer 121. The second interlayer dielectric layer 123 may include a contact hole through which the first connection electrode CNE1 passes. The contact hole of the second interlayer dielectric layer 123 may be connected to the contact hole of the first interlayer dielectric layer 121 and the contact hole of the gate insulating layer 113.

The first connection electrode CNE1 may be disposed on the second interlayer dielectric layer 123. The first connection electrode CNE1 may connect (e.g., electrically connect) the drain electrode DE of the thin-film transistor TFT with the second connection electrode CNE2. The first connection electrode CNE1 may be inserted into a contact hole formed in the first interlayer dielectric layer 121, the second interlayer dielectric layer 123 and the gate insulating layer 113 to be in contact with the drain electrode DE of the thin-film transistor TFT.

The first via layer 125 may cover the first connection electrode CNE1 and the second interlayer dielectric layer 123. The first via layer 125 may provide a flat surface over the underlying elements/members/structures. The first via layer 125 may include a contact hole through which the second connection electrode CNE2 passes.

The second connection electrode CNE2 may be disposed on the first via layer 125. The second connection electrode CNE2 may be inserted into a contact hole formed in the first via layer 125 to be in contact with the first connection electrode CNE1. The second connection electrode CNE2 may connect (e.g., electrically connect) the first connection electrode CNE1 with a first electrode AE1.

The second via layer 127 may cover the second connection electrode CNE2 and the first via layer 125. The second via layer 127 may include a contact hole through which the first electrode AE1 passes.

The display element layer 150 may be disposed on the thin-film transistor layer 130. The display element layer 150 according to an embodiment may include a first light-emitting member 150-1 and a second light-emitting member 150-2. The first light-emitting member 150-1 and the second light-emitting member 150-2 may be sequentially stacked in the third direction (e.g., Z-axis direction). As the display device 10 according to an embodiment includes the first light-emitting member 150-1 and the second light-emitting member 150-2 including different emission portions, the emission areas may be enlarged while the non-emission area may be reduced. In this manner, the display device 10 according to an embodiment may be implemented to have a high aperture ratio and a high resolution.

The first light-emitting member 150-1 may be disposed on the second via layer 127. The first light-emitting member 150-1 may include a first display element ED1, a first pixel-defining layer 151, a residual pattern layer 153 (or first pattern layer), and a bank member 160.

The first pixel-defining layer 151 may be disposed on the second via layer 127 and the first electrode AE1. First pixel-defining layers 151 may overlap the first to third emission areas EA1, EA2, and EA3, respectively, such that the first to third emission areas EA1, EA2, and EA3 may be spaced apart from one another. The first pixel-defining layer 151 according to an embodiment may include first openings OP1 that define the first emission portion EA1a of the first emission area EA1, the first emission portion EA2a of the second emission area EA2, and the first emission portion EA3a of the third emission area EA3. The first openings OP1 may overlap (e.g., align with) the first to third emission areas EA1, EA2 and EA3, respectively, to expose the first electrodes AE1. For example, the first emission portion EA1a of the first emission area EA1, the first emission portion EA2a of the second emission area EA2, and the first emission portion EA3a of third emission area EA3 may be defined by the first pixel-defining layer 151.

In some embodiments, the first pixel-defining layer 151 may include a first portion 151a and a second portion 151b. This will be described in detail later.

The first pixel-defining layer 151 may include an inorganic insulating material. For example, the first pixel-defining layer 151 may include aluminum oxide, titanium oxide, tantalum oxide, hafnium oxide, zinc oxide, silicon oxide, silicon nitride, and silicon oxynitride.

The bank member 160 may be disposed on the first pixel-defining layer 151. The bank member 160 may include a first bank layer 161 and a second bank layer 163 that include different metal materials to perform different functions. The second bank layer 163 may have tip portions TIP that protrude from the first bank layer 161 in the first direction (e.g., X-axis direction) toward the first emission portion EA1a of the first emission area EA1, the first emission portion EA2a of the second emission area EA2, and the first emission portion EA3a of the third emission area EA3.

The first display element ED1 may be disposed on the second via layer 127. According to an embodiment, the first display element ED1 may include a first light-emitting element ED11 overlapping the first emission portion EA1a of the first emission area EA1, a second light-emitting element ED12 overlapping the first emission portion EA2a of the second emission area EA2, and a third light-emitting element ED13 overlapping the first emission portion EA3a of the third emission area EA3. The first display element ED1 may include a first electrode AE1, a first display emissive layer EL1, and a second electrode CE1. For example, the first light-emitting element ED11 may include a first anode electrode AE11, a first emissive layer EL11 and a first cathode electrode CE11, the second light-emitting element ED12 may include a second anode electrode AE12, a second emissive layer EL12 and a second cathode electrode CE12, and the third light-emitting element ED13 may include a third anode electrode AE13, a third emissive layer EL13 and a third cathode electrode CE13.

According to some embodiments, the first light-emitting element ED11, the second light-emitting element ED12 and the third light-emitting element ED13 may emit light of different colors. For example, the first light-emitting element ED11 may emit light of a first color, i.e., red light, the second light-emitting element ED12 may emit light of a second color, i.e., green light, and the third light-emitting element ED13 may emit light of a third color, i.e., blue light.

The first electrode AE1 may be disposed on the second via layer 127. According to an embodiment, the first electrode AE1 may be connected (e.g., electrically connected) to the drain electrode DE of the thin-film transistor TFT through the first connection electrode CNE1 and the second connection electrode CNE2 on the opposite side in the third direction (e.g., Z-axis direction). According to an embodiment, the first electrode AE1 may be connected (e.g., electrically connected) to the third electrode AE2 through the first bank layer 161 and the second bank layer 163 on a side in the third direction (e.g., Z-axis direction).

For example, the first electrode AE1 may have a stack structure of a material layer having a high work function such as indium-tin-oxide (ITO), indium-zinc-oxide (IZO), zinc oxide (ZnO) and indium oxide (In₂O₃), and a reflective material layer such as silver (Ag), magnesium (Mg), aluminum (Al), platinum (Pt), lead (Pb), palladium (Pd), gold (Au), nickel (Ni), neodymium (Nd), iridium (Ir), chromium (Cr), lithium (Li), calcium (Ca) or a mixture thereof. For example, the first electrode AE1 may have a multilayer structure of ITO/Mg, ITO/MgF, ITO/Ag, and ITO/Ag/ITO. However, embodiments are not limited thereto.

According to an embodiment, the first electrode AE1 may include a first anode electrode AE11 overlapping the first emission portion EA1a of the first emission area EA1 and the second emission portion EA2b of the second emission area EA2, a second anode electrode AE12 overlapping the first emission portion EA2a of the second emission area EA2 and the second emission portion EA1b of the first emission area EA1, and a third anode electrode AE13 overlapping the first emission portion EA3a of the third emission area EA3 and the second emission portion EA2b of the second emission area EA2.

The first anode electrode AE11, the second anode electrode AE12 and the third anode electrode AE13 may be spaced apart from one another in the first direction (e.g., X-axis direction) by the first portion 151a of the first pixel-defining layer 151.

The first display emissive layer EL1 may be disposed on the first electrode AE1. The first display emissive layer EL1 may be an organic emissive layer made of an organic material, and may be formed on the first electrode AE1 by a deposition process or a photo pattern process during the fabrication process. In case that the thin-film transistor TFT applies a certain voltage to the first electrode AE1 and the second electrode CE1 receives a cathode voltage, holes and electrons may move to the first display emissive layer EL1 through a hole transporting layer and an electron transporting layer, respectively, and they may combine in the first display emissive layer EL1 to emit light.

According to an embodiment, the first display emissive layer EL1 may include a first emissive layer EL11 overlapping the first emission portion EA1a of the first emission area EA1, a second emissive layer EL12 overlapping the first emission portion EA2a of the second emission area EA2, and a third emissive layer EL13 overlapping the first emission portion EA3a of the third emission area EA3. According to an embodiment, the first display emissive layer EL1 may emit lights of different colors according to the materials included in the first emissive layer EL11, the second emissive layer EL12 and the third emissive layer EL13. For example, the first emissive layer EL11 may emit red light of the first color, the second emissive layer EL12 may emit green light of the second color, and the third emissive layer EL13 may emit blue light of the third color. It should be understood, however, that embodiments are not limited thereto. For example, the first display emissive layer EL1 may be disposed separately in each of the first to third emission areas EA1, EA2 and EA3 and may be in contact with the first bank layer 161 in the non-emission area NLA.

In some embodiments, a residual pattern layer 153 (or first pattern layer) may be disposed between the first electrode AE1 and the first pixel-defining layer 151 in the third direction (e.g., Z-axis direction) in the non-emission area NLA. The residual pattern layer 153 will be described later.

The second electrode CE1 may be disposed on the first display emissive layer EL1. The second electrode CE1 may include a transparent conductive material so that light generated in the first display emissive layer EL1 may be output. The second electrode CE1 may receive a common voltage or a low-level voltage. For example, in case that the first electrode AE1 receives the voltage equal to the data voltage and the second electrode CE1 receives the low-level voltage, a potential difference may be formed between the first electrodes AE1 and the second electrode CE1, so that the first display emissive layer EL1 may emit light.

According to an embodiment, the second electrode CE1 may include a material having a small work function such as Li, Ca, LiF/Ca, LiF/AI, Al, Mg, Ag, Pt, Pd, Ni, Au, Nd, Ir, Cr, BaF, Ba, or a compound or mixture thereof. The second electrode CE1 may further include a transparent metal oxide layer disposed on the material layer having a small work function.

According to an embodiment, the second electrode CE1 may include a first cathode electrode CE11 overlapping the first emission portion EA1a of the first emission area EA1, a second cathode electrode CE12 overlapping the first emission portion EA2a of the second emission area EA2, and a third cathode electrode CE13 overlapping the first emission portion EA3a of the third emission area EA3. The first cathode electrode CE11 may be disposed on the first emissive layer EL11, may cover (e.g., completely cover) the first emissive layer EL11, and may be in contact with the first bank layer 161. The second cathode electrode CE12 may be disposed on the second emissive layer EL12, may cover (e.g., completely cover) the second emissive layer EL12, and may be in contact with the first bank layer 161. The third cathode electrode CE13 may be disposed on the third emissive layer EL13, may cover (e.g., completely cover) the third emissive layer EL13, and may be in contact with the first bank layer 161. For example, according to an embodiment, the second electrode CE1 may be disposed separately in each of the first to third emission areas EA1, EA2 and EA3 and may be connected (e.g., electrically connected) to another one through the first bank layer 161.

The thin-film encapsulation layer 170 according to an embodiment may include a first thin-film encapsulation layer 170-1 and a second thin-film encapsulation layer 170-2. The first thin-film encapsulation layer 170-1 may include a first encapsulation layer 171, a second encapsulation layer 173, and a third encapsulation layer 175. The second thin-film encapsulation layer 170-2 will be described later.

The first encapsulation layer 171 may be disposed on the bank member 160 and the first display element ED1. The first encapsulation layer 171 may cover along the profile formed by the bank member 160 and the first display element ED1. For example, the first encapsulation layer 171 may have different levels according to the underlying element/structure it covers.

The first encapsulation layer 171 may include a first inorganic layer 171-1, a second inorganic layer 171-2 and a third inorganic layer 171-3 disposed in the first to third emission areas EA1, EA2 and EA3, respectively. The first inorganic layer 171-1, the second inorganic layer 171-2, and the third inorganic layer 171-3 may be spaced apart from one another in the first direction (e.g., X-axis direction) with the bank member 160 and the third electrode AE2 included in the second light-emitting member 150-2 interposed between the first inorganic layer 171-1, the second inorganic layer 171-2 and the third inorganic layer 171-3.

The first encapsulation layer 171 may include an inorganic material to prevent oxygen or moisture from permeating into the first light-emitting member 150-1. For example, the first encapsulation layer 171 may include aluminum oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

The second encapsulation layer 173 may be disposed on the first encapsulation layer 171. The second encapsulation layer 173 may overlap the first emission portion EA1a of the first emission area EA1, the first emission portion EA2a of the second emission area EA2, and the first emission portion EA3a of the third emission area EA3. The second encapsulation layer 173 may not overlap the second emission portion EA1b of the first emission area EA1, the second emission portion EA2b of the second emission area EA2, and the second emission portion EA3b of the third emission area EA3.

The second encapsulation layer 173 may include a first organic layer 173-1 overlapping the first emission portion EA1a of the first emission area EA1, a second organic layer 173-2 overlapping the first emission portion EA2a of the second emission area EA2, and a third organic layer 173-3 overlapping the first emission portion EA3a of the third emission area EA3. The first organic layer 173-1, the second organic layer 173-2 and the third organic layer 173-3 may be spaced apart from one another in the first direction (e.g., X-axis direction) with the first encapsulation layer 171 and the bank member 160 interposed between the first organic layer 173-1, the second organic layer 173-2 and the third organic layer 173-3.

The second encapsulation layer 173 may include an organic material and may protect the first light-emitting member 150-1 from particles such as dust. For example, the second encapsulation layer 173 may provide a flat surface over the first encapsulation layer 171 having different levels. For example, the second encapsulation layer 173 may include a silicone resin, an acrylic resin, an epoxy resin, and mixtures thereof.

The third encapsulation layer 175 may be disposed on the first encapsulation layer 171 and the second encapsulation layer 173. The third encapsulation layer 175 may cover (e.g., completely cover) the first encapsulation layer 171 and the second encapsulation layer 173.

The third encapsulation layer 175 may include a first inorganic layer 175-1, a second inorganic layer 175-2 and a third inorganic layer 175-3 disposed in the first to third emission areas EA1, EA2 and EA3, respectively. The first inorganic layer 175-1, the second inorganic layer 175-2 and the third inorganic layer 175-3 may be spaced apart from one another in the first direction (e.g., X-axis direction) with the bank member 160 and the third electrode AE2 included in the second light-emitting member 150-2 interposed between first inorganic layer 175-1, the second inorganic layer 175-2 and the third inorganic layer 175-3.

The third encapsulation layer 175 may include an inorganic material to prevent oxygen or moisture from permeating into the first light-emitting member 150-1. For example, the third encapsulation layer 175 may include aluminum oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

The second light-emitting member 150-2 may be disposed on the first thin-film encapsulation layer 170-1 and the second bank layer 163. The second light-emitting member 150-2 may include a second display element ED2, a second pixel-defining layer 155, and a residual pattern layer 157 (or second pattern layer).

The second pixel-defining layer 155 may be disposed on the third encapsulation layer 175 included in the first thin-film encapsulation layer 170-1. Second pixel-defining layers 155 may be disposed to overlap the first to third emission areas EA1, EA2, and EA3, respectively, such that the first to third emission areas EA1, EA2, and EA3 may be spaced apart from one another. For example, the second pixel-defining layers 155 may be disposed to overlap the first emission portion EA1a of the first emission area EA1, the first emission portion EA2a of the second emission area EA2, and the first emission portion EA3a of the third emission area EA3.

The second pixel-defining layer 155 according to an embodiment may include second openings OP2 that define the second emission portion EA1b of the first emission area EA1, the second emission portion EA2b of the second emission area EA2, and the second emission portion EA3b of the third emission area EA3. The second openings OP2 may overlap (e.g., align with) the first to third emission areas EA1, EA2 and EA3, respectively, to expose the third electrodes AE2. For example, the second emission portion EA1b of the first emission area EA1, the second emission portion EA2b of the second emission area EA2, and the second emission portion EA3b of third emission area EA3 may be defined by the second pixel-defining layer 155.

According to an embodiment, the second pixel-defining layer 155 may include a transparent inorganic insulating material. For example, the second pixel-defining layer 155 may include aluminum oxide, titanium oxide, tantalum oxide, hafnium oxide, zinc oxide, silicon oxide, silicon nitride, and silicon oxynitride. Accordingly, the second pixel-defining layer 155 according to an embodiment may transmit light output from the first display element ED1 even though the second pixel-defining layer 155 is disposed to overlap the first display element ED1 in the third direction (e.g., Z-axis direction).

The second display element ED2 may be disposed on the second bank layer 163 and the third encapsulation layer 175. According to an embodiment, the second display element ED2 may include a first light-emitting element ED21 overlapping the second emission portion EA1b of the first emission area EA1, a second light-emitting element ED22 overlapping the second emission portion EA2b of the second emission area EA2, and a third light-emitting element ED23 overlapping the second emission portion EA3b of the third emission area EA3. The second display element ED2 may include a third electrode AE2, a second display emissive layer EL2, and a common electrode CE2. For example, according to an embodiment, the first light-emitting element ED21 may include a first anode electrode AE21, a first emissive layer EL21 and a common electrode CE2, the second light-emitting element ED22 may include a second anode electrode AE22, a second emissive layer EL22 and a common electrode CE2, and the third light-emitting element ED23 may include a third anode electrode AE23, a third emissive layer EL23 and a common electrode CE2.

According to some embodiments, the first light-emitting element ED21, the second light-emitting element ED22 and the third light-emitting element ED23 may emit light of different colors. For example, the first light-emitting element ED21 may emit light of a first color, e.g., red light, the second light-emitting element ED22 may emit light of a second color, e.g., green light, and the third light-emitting element ED23 may emit light of a third color, e.g., blue light.

The third electrode AE2 may be disposed on the second bank layer 163 and the third encapsulation layer 175. The third electrode AE2 may be in contact with the second bank layer 163 and the third encapsulation layer 175. According to an embodiment, the third electrode AE2 may be connected (e.g., electrically connected) to the second bank layer 163, the first bank layer 161 and the first electrode AE1 in the third direction (e.g., Z-axis direction).

For example, the third electrode AE2 may have a stack structure of a material layer having a high work function such as indium-tin-oxide (ITO), indium-zinc-oxide (IZO), zinc oxide (ZnO) and indium oxide (In₂O₃), and a reflective material layer such as silver (Ag), magnesium (Mg), aluminum (Al), platinum (Pt), lead (Pb), palladium (Pd), gold (Au), nickel (Ni), neodymium (Nd), iridium (Ir), chromium (Cr), lithium (Li), calcium (Ca) or a mixture thereof. For example, the third electrode AE2 may have a multilayer structure of ITO/Mg, ITO/MgF, ITO/Ag, and ITO/Ag/ITO. However, embodiments are not limited thereto.

According to an embodiment, the third electrode AE2 may include a first anode electrode AE21 overlapping the second emission portion EA1b of the first emission area EA1, a second anode electrode AE22 overlapping the second emission portion EA2b of the second emission area EA2, and a third anode electrode AE23 overlapping the second emission portion EA3b of the third emission area EA3.

The first anode electrode AE21, the second anode electrode AE22 and the third anode electrode AE23 may be spaced apart from one another in the first direction (e.g., X-axis direction) by the second pixel-defining layer 155.

The second display emissive layer EL2 may be disposed on the third electrode AE2. The second display emissive layer EL2 may be an organic emissive layer made of an organic material, and may be formed on the third electrode AE2 by a deposition process or a photo pattern process during the fabrication process. In case that the thin-film transistor TFT applies a certain voltage to the third electrode AE2 and the common electrode CE2 receives a common voltage, the holes and electrons may move to the second display emissive layer EL2 through a hole transporting layer and an electron transporting layer, respectively, and they may combine in the second display emissive layer EL2 to emit light.

According to an embodiment, the second display emissive layer EL2 may include a first emissive layer EL21 overlapping the second emission portion EA1b of the first emission area EA1, a second emissive layer EL22 overlapping the second emission portion EA2b of the second emission area EA2, and a third emissive layer EL23 overlapping the second emission portion EA3b of the third emission area EA3. According to an embodiment, the second display emissive layer EL2 may emit lights of different colors according to the materials included in the first emissive layer EL21, the second emissive layer EL22 and the third emissive layer EL23. For example, the first emissive layer EL21 may emit red light of the first color, the second emissive layer EL22 may emit green light of the second color, and the third emissive layer EL23 may emit blue light of the third color. It should be understood, however, that embodiments are not limited thereto.

In some embodiments, a residual pattern layer 157 (or second pattern layer) may be disposed between the third electrode AE2 and the second pixel-defining layer 155 in the third direction (e.g., Z-axis direction) in the non-emission area NLA. The residual pattern layer 157 will be described later.

The common electrode CE2 may be disposed on the entire surface of the second display emissive layer EL2 and the second pixel-defining layer 155. For example, the common electrode CE2 may be a common layer disposed across the first to third emission areas EA1, EA2 and EA3 and the non-emission area NLA. The common electrode CE2 may include a transparent conductive material so that light generated in the second display emissive layer EL2 may be output.

According to an embodiment, the common electrode CE2 may include a material layer having a small work function such as Li, Ca, LiF/Ca, LiF/AI, Al, Mg, Ag, Pt, Pd, Ni, Au, Nd, Ir, Cr, BaF and Ba, or a compound or mixture thereof (e.g., a mixture of Ag and Mg). The common electrode CE2 may further include a transparent metal oxide layer disposed on the material layer having a small work function.

The second thin-film encapsulation layer 170-2 may be disposed on the second light-emitting member 150-2. The second thin-film encapsulation layer 170-2 may include a first encapsulation layer 177, a second encapsulation layer 178, and a third encapsulation layer 179.

The first encapsulation layer 177 may be disposed (e.g., entirely disposed) on the common electrode CE2. The first encapsulation layer 177 may include an inorganic material and may cover (e.g., completely cover) the common electrode CE2. The first encapsulation layer 177 may prevent oxygen or moisture from permeating into the second light-emitting member 150-2. For example, the second encapsulation layer 178 may be disposed (e.g., entirely disposed) on the first encapsulation layer 177. The second encapsulation layer 178 may protect the second light-emitting member 150-2 from particles such as dust and may provide a flat surface over the first encapsulation layer 177 having different levels. For example, the third encapsulation layer 179 may be formed (e.g., entirely formed) on the second encapsulation layer 178. The third encapsulation layer 179 may include an inorganic material and may cover (e.g., completely cover) the second encapsulation layer 178.

For example, the first encapsulation layer 177 and the third encapsulation layer 179 may include at least one of: aluminum oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O). For example, the second encapsulation layer 178 may include a silicone resin, an acrylic resin, an epoxy resin, and mixtures thereof.

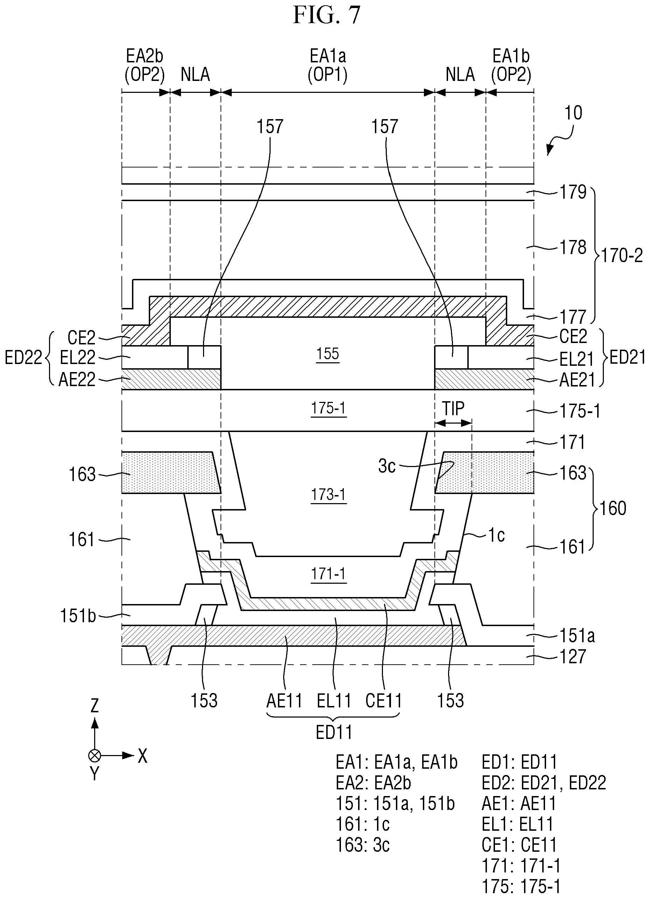

FIG. 7 is an enlarged schematic cross-sectional view of the first emission portion EA1a of the first emission area EA1 in FIG. 6.

Referring to FIG. 7, the first emission portion EA1a of the first emission area EA1 may be adjacent to non-emission areas NLA in the first direction (e.g., X-axis direction), and the first emission portion EA1a of the first emission area EA1 may be spaced apart from the second emission portion EA2b of the second emission area EA2 on the opposite side in the first direction (e.g., X-axis direction) with the non-emission area NLA interposed between the first emission portion EA1a of the first emission area EA1 and the second emission portion EA2b of the second emission area EA2. For example, the first emission portion EA1a of the first emission area EA1 may be spaced apart from the second emission portion EA1b of the first emission area EA1 on a side in the first direction (e.g., X-axis direction) with the non-emission area NLA interposed between the first emission portion EA1a of the first emission area EA1 and the second emission portion EA1b of the first emission area EA1.

As described above, the first pixel-defining layer 151 according to an embodiment may include a first opening OP1 defining the first emission portion EA1a of the first emission area EA1, and the first opening OP1 may expose a part of the first display element ED1.

According to an embodiment, the first pixel-defining layer 151 may include a first portion 151a and a second portion 151b. The first portion 151a and the second portion 151b may expose a part of the first display element ED1 and may be spaced apart from each other in the first direction (e.g., X-axis direction). For example, the first portion 151a may be disposed on the second via layer 127, and the second portion 151b may be spaced apart from the second via layer 127 and disposed on the first anode electrode AE11.

The first portion 151a and the second portion 151b of the first pixel-defining layer 151 may be formed as a single body during the fabrication process of the display device 10 and then may be separated by a photo pattern process. Accordingly, the first portion 151a and the second portion 151b may include the same material. The fabrication process will be described later.

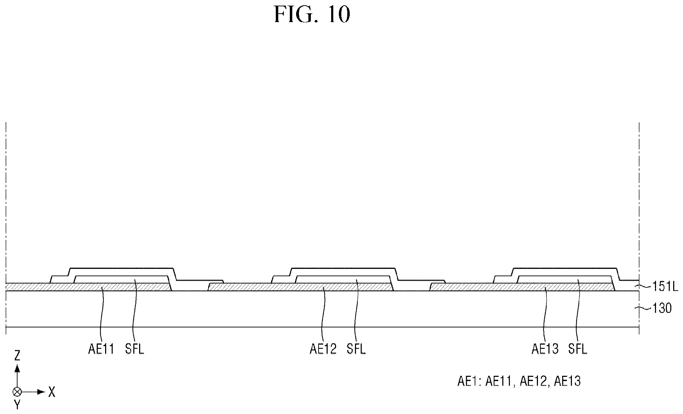

According to an embodiment, the display device 10 may include a sacrificial layer SFL (see FIG. 10) during a process of fabricating the first display element ED1. The sacrificial layer SFL may be disposed between the first pixel-defining layer 151 and the first electrode AE1, and then may be partially removed by a subsequent wet etching process. The part of the sacrificial layer SFL, which is not removed, may remain as a residual pattern layer 153 (or first pattern layer) between the first pixel-defining layer 151 and the first electrode AE1. The residual pattern layer 153 may overlap the non-emission area NLA in the third direction (e.g., Z-axis direction) and may be disposed in contact with the first display emissive layer EL1 in the first direction (e.g., X-axis direction).

In some embodiments, the residual pattern layer 153 may be surrounded (e.g., completely surrounded) by the first pixel-defining layer 151, the first display emissive layer EL1 and the first electrode AE1. The residual pattern layer 153 may be in contact with the first pixel-defining layer 151, the first display emissive layer EL1, and the first electrode AE1. For example, the residual pattern layer 153 may include at least one of indium-gallium-zinc oxide (IGZO), zinc-tin oxide (ZTO), indium-tin oxide (IZO), etc.

According to an embodiment, the first bank layer 161 may be disposed on the first pixel-defining layer 151. The first bank layer 161 may include a metal having high electrical conductivity. For example, the first bank layer 161 may include aluminum (Al).

According to some embodiments, the first bank layer 161 may include a side surface 1c facing the first emission portion EA1a of the first emission area EA1. The side surface 1c of the first bank layer 161 may include a structure that is recessed toward the non-emission area NLA than the first pixel-defining layer 151. The side surface 1c of the first bank layer 161 may be in contact with the first emissive layer EL11, the first cathode electrode CE11, and the first inorganic layer 171-1. As described above, the second electrode CE1 according to an embodiment may be disposed separately in each of the first to third emission areas EA1, EA2 and EA3. The separated second electrodes CE1 may be connected (e.g., electrically connected) to another one by the first bank layer 161.

For example, the first emissive layer EL11 and the first cathode electrode CE11 may be in contact with the side surface 1c of the first bank layer 161 in the non-emission area NLA. For example, the first emissive layer EL11 and the first cathode electrode CE11 may be in contact with the side surface 1c of the first bank layer 161 under the protruding tip portion TIP of the second bank layer 163. According to an embodiment, the first emissive layer EL11 may be covered (e.g., completely covered) by the first cathode electrode CE11.

The second bank layer 163 may be disposed on the first bank layer 161. The second bank layer 163 may include a material having a lower etching rate than the first bank layer 161, and for example, the second bank layer 163 may include titanium (Ti).

According to some embodiments, the second bank layer 163 may include a side surface 3c facing the first emission portion EA1a of the first emission area EA1. The side surface 3c of the second bank layer 163 may have a shape that protrudes toward the first emission portion EA1a than the side surface 1c of the first bank layer 161. For example, the side surface 1c of the first bank layer 161 may have a shape depressed from the side surface 3c of the second bank layer 163. Accordingly, the second bank layer 163 may include a tip portion TIP protruding toward the first emission portion EA1a, and accordingly an undercut portion may be formed between the tip portion TIP of the second bank layer 163 and the side surface 1c of the first bank layer 161.

According to some embodiments, the thickness of the second bank layer 163 in the third direction (e.g., Z-axis direction) may be lower than the thickness of the first bank layer 161.

According to an embodiment, the first inorganic layer 171-1 included in the first encapsulation layer 171 may cover (e.g., completely cover) the first cathode electrode CE11 in the first emission portion EA1a of the first emission area EA1. The first inorganic layer 171-1 may cover (e.g., completely cover) the side surface 1c of the first bank layer 161 and the protruding tip portion TIP of the second bank layer 163 in the non-emission area NLA. The first inorganic layer 171-1 may be in contact with the side surface 1c of the first bank layer 161 and the protruding tip portion TIP of the second bank layer 163.

For example, according to an embodiment, the first inorganic layer 171-1 may cover (e.g., completely cover) the second bank layer 163 in the second emission portion EA1b of the first emission area EA1 and the second emission portion EA2b of the second emission area EA2, and the first inorganic layer 171-1 may be in contact with the second bank layer 163.

According to an embodiment, the first organic layer 173-1 included in the second encapsulation layer 173 may be disposed on the first inorganic layer 171-1 in the first emission portion EA1a of the first emission area EA1. For example, the first organic layer 173-1 may not overlap the second emission portion EA1b of the first emission area EA1 or the second emission portion EA2b of the second emission area EA2. The first inorganic layer 175-1 included in the third encapsulation layer 175 may be disposed on the first organic layer 173-1, and the first organic layer 173-1 may be surrounded (e.g., completely surrounded) by the first encapsulation layer 171 and the third encapsulation layer 175.

According to an embodiment, the second display element ED2 may be disposed on the third encapsulation layer 175. As described above, the second display element ED2 may overlap the second emission portion EA1b of the first emission area EA1 and the second emission portion EA2b of the second emission area EA2, but the second display element ED2 may not overlap the first emission portion EA1a of the first emission area EA1.

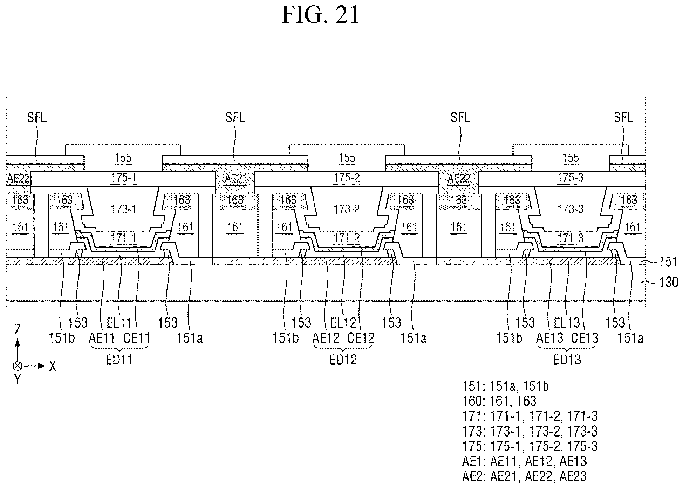

According to an embodiment, the display device 10 may include a sacrificial layer SFL (see FIG. 21) during a process of fabricating the second display element ED2. The sacrificial layer SFL may be disposed between the second pixel-defining layer 155 and the third electrode AE2, and then may be partially removed by a subsequent wet etching process. The part of the sacrificial layer SFL, which is not removed, may remain as a residual pattern layer 157 (or second pattern layer) between the second pixel-defining layer 155 and the third electrode AE2. The residual pattern layer 157 may overlap the non-emission area NLA in the third direction (e.g., Z-axis direction) and may be disposed in contact with the second display emissive layer EL2 in the first direction (e.g., X-axis direction).

According to some embodiments, the residual pattern layer 157 may be surrounded (e.g., completely surrounded) by the second pixel-defining layer 155, the second display emissive layer EL2 and the third electrode AE2. The residual pattern layer 157 may be in contact with the second pixel-defining layer 155, the second display emissive layer EL2, and the third electrode AE2. For example, the residual pattern layer 157 may include at least one of indium-gallium-zinc oxide (IGZO), zinc-tin oxide (ZTO), indium-tin oxide (IZO), etc.

The second pixel-defining layer 155 may be disposed on the first inorganic layer 175-1 in the first emission portion EA1a of the first emission area EA1. The second pixel-defining layer 155 may define the second emission portion EA1b of the first emission area EA1 and the second emission portion EA2b of the second emission area EA2. The second pixel-defining layer 155 may separate the first anode electrode AE21 from the second anode electrode AE22 in the first direction (e.g., X-axis direction).

According to an embodiment, the second pixel-defining layer 155 may overlap the first display element ED1 and the first thin-film encapsulation layer 170-1 in the third direction (e.g., Z-axis direction). Other redundant descriptions will be omitted for descriptive convenience.

Although the first emission portion EA1a of the first emission area EA1 and its periphery have been described in the drawings for convenience of illustration, it is to be understood that the first emission portion EA2a of the second emission area EA2 and its periphery, and the first emission portion EA3a of the third emission area EA3 and its periphery may include similar structures and features with the first emission portion EA1a of the first emission area EA1 and its periphery.

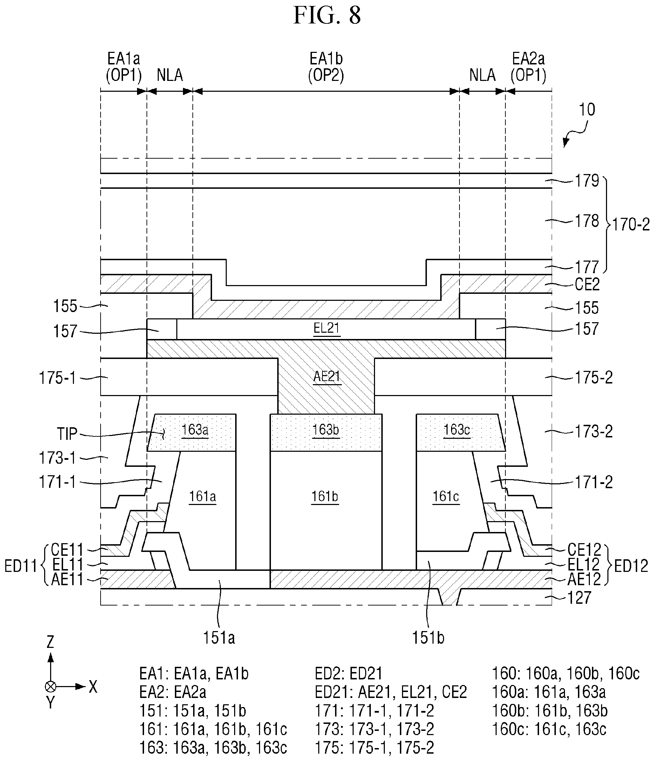

FIG. 8 is an enlarged schematic cross-sectional view of the second emission portion EA1b of the first emission area EA1 in FIG. 6.

Referring to FIG. 8, the second emission portion EA1b of the first emission area EA1 may be adjacent to non-emission areas NLA in the first direction (e.g., X-axis direction), and the second emission portion EA1b of the first emission area EA1 may be spaced apart from the first emission portion EA1a of the first emission area EA1 on the opposite side in the first direction (e.g., X-axis direction) with the non-emission area NLA interposed between the second emission portion EA1b of the first emission area EA1 and the first emission portion EA1a of the first emission area EA1. For example, the second emission portion EA1b of the first emission area EA1 may be spaced apart from the first emission portion EA2a of the second emission area EA2 on a side in the first direction (e.g., X-axis direction) with the non-emission area NLA interposed between the second emission portion EA1b of the first emission area EA1 and the first emission portion EA2a of the second emission area EA2 .

According to an embodiment, the first anode electrode AE11 and the second anode electrode AE12 may be spaced apart from each other in the first direction (e.g., X-axis direction) by the first portion 151a of the first pixel-defining layer 151. For example, the first anode electrode AE11 may be disposed in the first emission portion EA1a of the first emission area EA1, and the second anode electrode AE12 may be disposed in the second emission portion EA1b of the first emission area EA1 and the first emission portion EA2a of the second emission area EA2.

According to some embodiments, the first anode electrode AE11 in the first emission portion EA1a of the first emission area EA1 and the second anode electrode AE12 disposed in the first emission portion EA2a of the second emission area EA2 may not be in contact with the first bank layer 161, while the second anode electrode AE12 in the second emission portion EA1b of the first emission area EA1 may be in contact with the first bank layer 161.

According to an embodiment, the bank member 160 may include a first portion 160a, a second portion 160b, and a third portion 160c. The first portion 160a, the second portion 160b and the third portion 160c of the bank member 160 may be spaced apart from one another in the first direction (e.g., X-axis direction) with the first encapsulation layer 171 interposed between the first portion 160a, the second portion 160b, and the third portion 160c of the bank member 160. During the process of fabricating the display device 10, the first portion 160a, the second portion 160b and the third portion 160c of the bank member 160 may be formed as a single body, and then may be separated into the shape as shown in the drawings by a photo pattern process. Accordingly, the first portion 160a, the second portion 160b and the third portion 160c of the bank member 160 may include the same material. The fabrication process will be described later.

In some embodiments, the first portion 160a of the bank member 160 may include a first portion 161a of the first bank layer 161 and a first portion 163a of the second bank layer 163.

The first portion 161a of the first bank layer 161 may be disposed on the first portion 151a of the first pixel-defining layer 151. The first portion 161a may be disposed in contact with the first portion 151a of the first pixel-defining layer 151. The first portion 161a may be in contact with the first emissive layer EL11 and the first cathode electrode CE11 in the non-emission area NLA. The first portion 161a may be in contact with the first inorganic layer 171-1 in the second emission portion EA1b of the first emission area EA1. Accordingly, the first portion 161a of the first bank layer 161 may be in contact with the first emissive layer EL11, the first cathode electrode CE11, the first inorganic layer 171-1 and the first portion 151a of the first pixel-defining layer 151, and may be surrounded by the first emissive layer EL11, the first cathode electrode CE11, the first inorganic layer 171-1, the second bank layer 163 and the first portion 151a of the first pixel-defining layer 151.

The first portion 163a of the second bank layer 163 may be disposed on the first portion 161a of the first bank layer 161. The first portion 163a of the second bank layer 163 may have a tip portion TIP that protrudes toward the first emission portion EA1a of the first emission area EA1 than the first portion 161a of the first bank layer 161. The first portion 163a of the second bank layer 163 may be surrounded by the first inorganic layer 171-1.

In some embodiments, the second portion 160b of the bank member 160 may include a second portion 161b of the first bank layer 161 and a second portion 163b of the second bank layer 163.

The second portion 161b of the first bank layer 161 may be disposed on the second anode electrode AE12. The second portion 161b may be in contact with the second anode electrode AE12, and thus the second portion 161b may be connected (e.g., electrically connected) to the second anode electrode AE12.

The second portion 161b of the first bank layer 161 may be spaced apart from the first portion 161a in the first direction (e.g., X-axis direction) with the first inorganic layer 171-1 interposed between the second portion 161b of the first bank layer 161 and the first portion 161a. The second portion 161b may be in contact with the first inorganic layer 171-1 on the opposite side in the first direction (e.g., X-axis direction). The second portion 161b may be in contact with the second inorganic layer 171-2 on a side in the first direction (e.g., X-axis direction). For example, the first inorganic layer 171-1 and the second inorganic layer 171-2 may be separated from each other by the second portion 161b of the first bank layer 161.

The second portion 163b of the second bank layer 163 may be disposed on the second portion 161b of the first bank layer 161. The second portion 163b may be in contact with the first anode electrode AE21 on a side in the third direction (e.g., Z-axis direction), and may be in contact with the second portion 161b of the first bank layer 161 on the opposite side in the third direction (e.g., Z-axis direction). Accordingly, the first anode electrode AE11 and the first anode electrode AE21 may be connected (e.g., electrically connected) to each other by the second portion 160b of the bank member 160.

For example, the second portion 163b of the second bank layer 163 may be in contact with the second inorganic layer 171-2 on a side in the first direction (e.g., X-axis direction), and may be in contact with the first inorganic layer 171-1 on the opposite side in the first direction (e.g., X-axis direction).

In some embodiments, the third portion 160c of the bank member 160 may include a third portion 161c of the first bank layer 161 and a third portion 163c of the second bank layer 163.

The third portion 161c of the first bank layer 161 may be disposed on the second portion 151b of the first pixel-defining layer 151. For example, the third portion 161c may be disposed to overlap the second anode electrode AE12 in the third direction (e.g., Z-axis direction) but may not be in contact with the second anode electrode AE12.

The third portion 161c of the first bank layer 161 may be in contact with the second emissive layer EL12 and the second cathode electrode CE12 in the non-emission area NLA, and may be in contact with the second inorganic layer 171-2 in the second emission portion EA1b of the first emission area EA1. Accordingly, the third portion 161c may be in contact with the second emissive layer EL12, the second cathode electrode CE12, the second inorganic layer 171-2 and the second portion 151b of the first pixel-defining layer 151, and may be surrounded by the second emissive layer EL12, the second cathode electrode CE12, the second inorganic layer 171-2, the second bank layer 163 and the second portion 151b of the first pixel-defining layer 151.

The third portion 163c of the second bank layer 163 may be disposed on the third portion 161c of the first bank layer 161. The third portion 163c of the second bank layer 163 may have a tip portion TIP that protrudes toward the first emission portion EA2a of the second emission area EA2 than the third portion 161c of the first bank layer 161. The third portion 163c of the second bank layer 163 may be surrounded by the second inorganic layer 171-2.

According to an embodiment, the first anode electrode AE21 and the first emissive layer EL21 included in the second display element ED2 may overlap the first pixel-defining layer 151 in the third direction (e.g., Z-axis direction), and the first anode electrode AE21 and the first emissive layer EL21 included in the second display element ED2 may overlap the first portion 160a, the second portion 160b and the third portion 160c of the bank member 160 in the third direction (e.g., Z-axis direction). Other redundant descriptions will be omitted for descriptive convenience.

Although the second emission portion EA1b of the first emission area EA1 and its periphery have been described in the drawings for convenience of illustration, it is to be understood that the second emission portion EA2b of the second emission area EA2 and its periphery, and the second emission portion EA3b of the third emission area EA3 and its periphery may include similar structures and features with the second emission portion EA1b of the first emission area EA1 and its periphery.

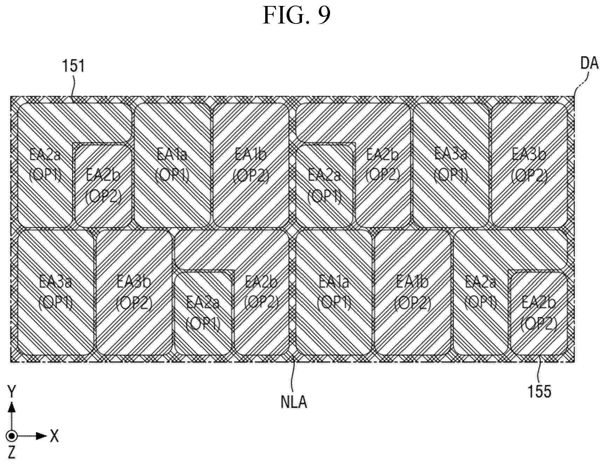

FIG. 9 is a schematic plan view showing a layout of the first pixel-defining layer 151 and the second pixel-defining layer 155 in FIG. 5.

Referring to FIG. 9, the first openings OP1 may be defined by the first pixel-defining layer 151 in plan view. The first emission portion EA1a of the first emission area EA1, the first emission portion EA2a of the second emission area EA2 and the first emission portion EA3a of the third emission area EA3 may be defined by the first openings OP1 in plan view. For example, the first pixel-defining layer 151 may surround (e.g., completely surround) the first emission portion EA1a of the first emission area EA1, the first emission portion EA2a of the second emission area EA2 and the first emission portion EA3a of the third emission area EA3 in plan view. For example, the first pixel-defining layer 151 may be in a mesh pattern to expose the first emission portion EA1a of the first emission area EA1, the first emission portion EA2a of the second emission area EA2, and the first emission portion EA3a of third emission area EA3 in plan view.

For example, the second openings OP2 may be defined by the second pixel-defining layer 155 in plan view. The second emission portion EA1b of the first emission area EA1, the second emission portion EA2b of the second emission area EA2 and the second emission portion EA3b of the third emission area EA3 may be defined by the second openings OP2 in plan view. For example, the second pixel-defining layer 155 may surround (e.g., completely surround) the second emission portion EA1b of the first emission area EA1, the second emission portion EA2b of the second emission area EA2 and the second emission portion EA3b of the third emission area EA3 in plan view. For example, the second pixel-defining layer 155 may be in a mesh pattern to expose the second emission portion EA1b of the first emission area EA1, the second emission portion EA2b of the second emission area EA2, and the second emission portion EA3b of third emission area EA3 in plan view.

As shown in FIG. 9, a part of the first pixel-defining layer 151 and a part of the second pixel-defining layer 155 may overlap each other in the third direction (e.g., Z-axis direction). The portion, in which the first pixel-defining layer 151 and the second pixel-defining layer 155 overlap each other in the third direction (e.g., Z-axis direction) in plan view (orwhen viewed from the top), may be defined as a non-emission area NLA.

FIGS. 10, 11, 12, 13, 14, 15, 16, 17, 18, 19, 20, 21, 22, and 23 are schematic cross-sectional views for illustrating a method of fabricating the display element layer 150 in FIG. 6. For example, FIGS. 10 to 23 are schematic cross-sectional views showing a process of fabricating a first light-emitting member 150-1 and a second light-emitting member 150-2 of the display element layer 150.

Referring to FIG. 10, a first electrode AE1 may be formed on the thin-film transistor layer 130, and a sacrificial layer SFL may be formed on the first electrode AE1. The first electrode AE1 may include a first anode electrode AE11, a second anode electrode AE12, and a third anode electrode AE13. The first anode electrode AE11, the second anode electrode AE12 and the third anode electrode AE13 may be spaced apart from one another on the thin-film transistor layer 130. The first anode electrode AE11 may be disposed across the first emission portion EA1a of the first emission area EA1 and the second emission portion EA2b of the second emission area EA2. The second anode electrode AE12 may be disposed across the second emission portion EA1b of the first emission area EA1 and the first emission portion EA2a of the second emission area EA2. The third anode electrode AE13 may be disposed across the first emission portion EA3a of the third emission area EA3 and the second emission portion EA2b of the second emission area EA2. For example, the thin-film transistor layer 130 may be disposed on the substrate 110, and the structure of the thin-film transistor layer 130 has been described above with reference to FIG. 6. The detailed description will be omitted for descriptive convenience.

For example, a first pixel-defining material layer 151L may be formed to cover the first anode electrode AE11, the second anode electrode AE12, the third anode electrode AE13 and sacrificial layers SFL. The first pixel-defining material layer 151L may cover (e.g., completely cover) the sacrificial layers SFL disposed on each of the first anode electrode AE11, the second anode electrode AE12 and the third anode electrode AE13, and may overlap each of the first anode electrode AE11, the second anode electrode AE12 and the third anode electrode AE13 such that the first anode electrode AE11, the second anode electrode AE12 and the third anode electrode AE13 may be spaced apart from one another.

The sacrificial layer SFL may prevent the upper surface of the first electrode AE1 from being in contact with the first pixel-defining layer 151. The sacrificial layer SFL may include an oxide semiconductor. For example, the sacrificial layer SFL may include at least one of indium-gallium-zinc oxide (IGZO), zinc-tin oxide (ZTO), indium-tin oxide (IZO), etc.

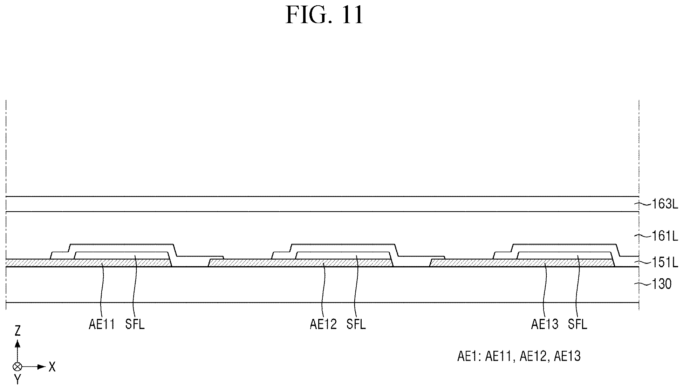

For example, referring to FIG. 11, a first bank material layer 161L may be formed to cover (e.g., entirely cover) the first electrode AE1 and the first pixel-defining material layer 151L, and a second bank material layer 163L may be formed (e.g., entirely formed) on the first bank material layer 161L.

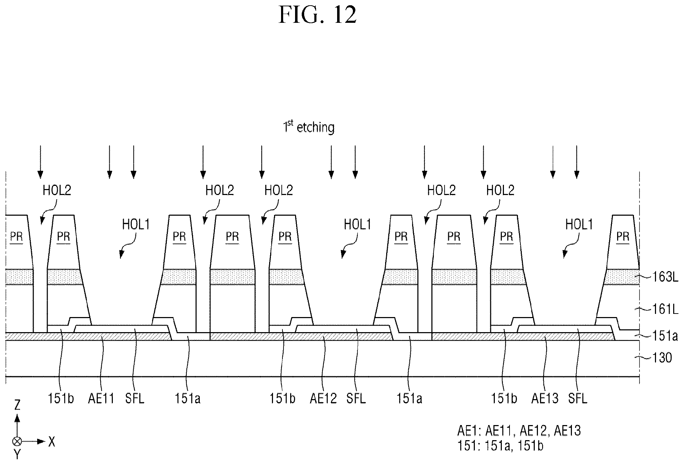

For example, referring to FIG. 12, a photoresist PR may be formed on the second bank material layer 163L, and the first bank material layer 161L and the second bank material layer 163L may be partially etched using the photoresist PR as a mask (1^{st} etching). The photoresist PR may be separated on the bank material layers 161L and 163L.

For example, the first (1^{st}) etching process may be carried out as dry etching. As the first etching process (1^{st} etching) is performed as a dry etching process, the first pixel-defining material layer 151L including an inorganic material, and the first bank material layer 161L and the second bank material layer 163L including different metal materials may be etched.

By this process, first holes HOL1 may be formed to overlap the first anode electrode AE11, the second anode electrode AE12 and the third anode electrode AE13, respectively, and second holes HOL2 may be formed to overlap parts of the second bank material layer 161L and the second bank material layer 163L. For example, by this process, the first pixel-defining material layer 151L may be divided into a first portion 151a and a second portion 151b.

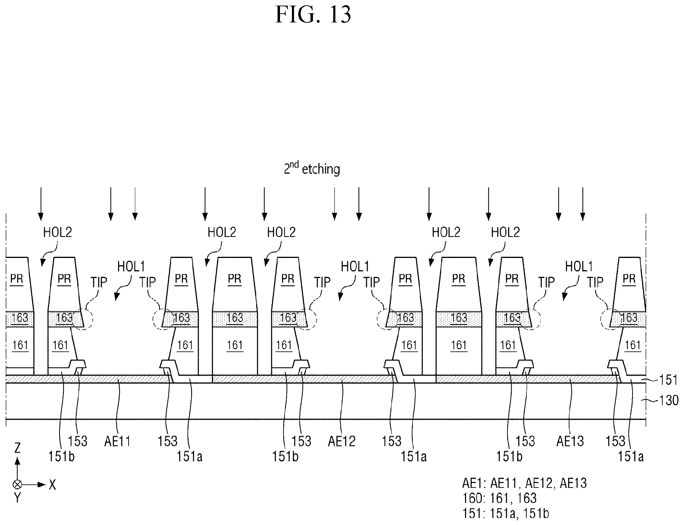

For example, referring to FIG. 13, a second etching process (2^{nd} etching) may be performed to form tip portions TIP of the bank member 160 shown in FIG. 6 are formed and partially remove the sacrificial layer SFL. For example, the second etching process may be conducted as a wet etching process.

By this process, the sacrificial layer SFL disposed on the first anode electrode AE11, the second anode electrode AE12 and the third anode electrode AE13 may be removed partially. It should be noted that the sacrificial layer SFL may not be completely removed but may remain in the space between the first pixel-defining layer 151 and the first electrode AE1 in the third direction (e.g., Z-axis direction) as a residual pattern layer 153 (or first pattern layer).

According to an embodiment, the first bank material layer 161L may include a material that has a faster etching rate than the second bank material layer 163L. Accordingly, by performing this etching process, the side surface 1c of the second bank material layer 163L may protrude from the side surface 1c of the first bank material layer 161L, and the first bank layer 161 and the first bank layer 161 may have the shape shown in FIG. 6. For example, the second bank layer 163 may have tip portions TIP protruding toward the first openings OP1 from the side surfaces 1c of the first bank layer 161, and undercut portions may be formed between the tip portions TIP of the second bank layer 163 and the side surfaces 1c of the first bank layer 161.

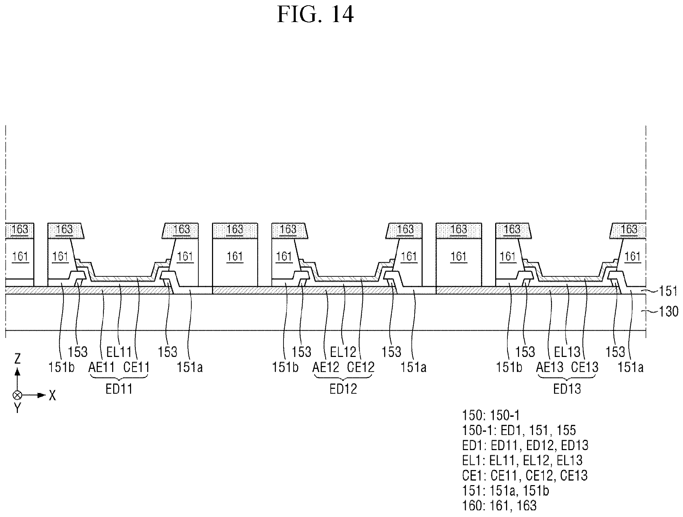

For example, referring to FIG. 14, a first display emissive layer EL1 may be deposited on each of the first anode electrode AE11, the second anode electrode AE12 and the third anode electrode AE13. The first display emissive layer EL1 may include a first emissive layer EL11 in contact with the first anode electrode AE11, a second emissive layer EL12 in contact with the second anode electrode AE12, and a third emissive layer EL13 in contact with the third anode electrode AE13. The first display emissive layer EL1 may be formed to overlap each of the first anode electrode AE11, the second anode electrode AE12 and the third anode electrode AE13 by a thermal evaporation process or a photo lithography process.

For example, the second electrode CE1 may be deposited on each of the first emissive layer EL11, the second emissive layer EL12 and the third emissive layer EL13. The second electrode CE1 may include a first cathode electrode CE11 in contact with the first emissive layer EL11, a second cathode electrode CE12 in contact with the second emissive layer EL12, and a third cathode electrode CE13 in contact with the third emissive layer EL13. The second electrode CE1 may be formed on each of the first emissive layer EL11, the second emissive layer EL12 and the third emissive layer EL13 by a thermal evaporation process or a photo pattern process (photo lithography). By this process, a first display element ED1 included in the first light-emitting member 150-1 may be formed.

As described above, the first display emissive layer EL1 and the second electrode CE1 may be in contact with the side surface 1c of the first bank layer 161, and the second electrode CE1 may be connected (e.g., electrically connected) to another one by the first bank layer 161.

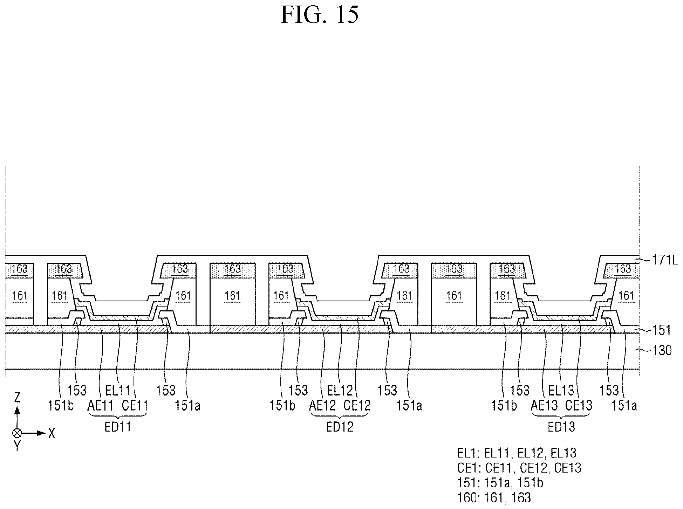

For example, referring to FIG. 15, a first encapsulation material layer 171L may be formed to cover (e.g., entirely cover) the second electrodes CE1 and the bank member 160. The first encapsulation material layer 171L may include an inorganic material and may cover along the profile formed by the second electrodes CE1 and the bank member 160. Accordingly, the first encapsulation material layer 171L may include different levels.

According to an embodiment, by this process, the first light-emitting element ED11, the second light-emitting element ED12 and the third light-emitting element ED13 may be covered (e.g., completely covered) by the first encapsulation layer 171.

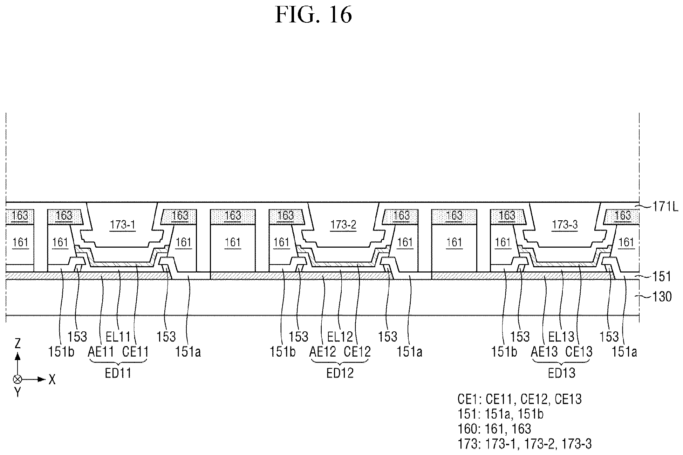

For example, referring to FIG. 16, a second encapsulation layer 173 may be applied to provide a flat surface over the first encapsulation material layer 171L overlapping each of the first light-emitting element ED11, the second light-emitting element ED12 and the third light-emitting element ED13. The second encapsulation layer 173 may overlap each of the first light-emitting element ED11, the second light-emitting element ED12 and the third light-emitting element ED13 and spaced apart from each other. The second encapsulation layer 173 may include a first organic layer 173-1 overlapping the first light-emitting element ED11, a second organic layer 173-2 overlapping the second light-emitting element ED12, and a third organic layer 173-3 overlapping the third light-emitting element ED13.

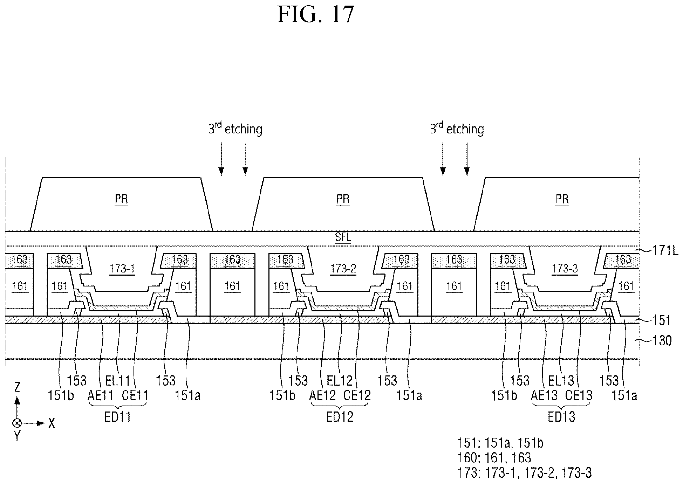

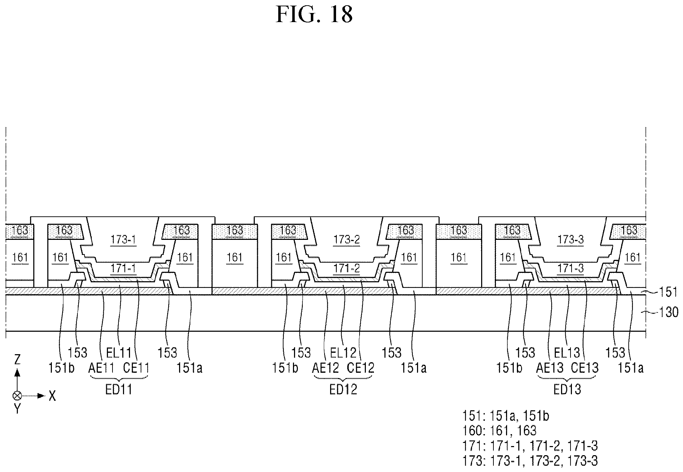

Referring to FIGS. 17 and 18, a sacrificial layer SFL may be formed (e.g., entirely formed) on the first encapsulation material layer 171L and the second encapsulation layer 173, and a photoresist PR may be formed on the sacrificial layer SFL such that the photoresist PR may overlap the first light-emitting element ED11, the second light-emitting element ED12 and the third light-emitting element ED13. According to an embodiment, the sacrificial layer SFL may include the same material as the sacrificial layer SFL described above with reference to FIGS. 10 to 12. For example, a third etching process (3^{rd} etching) may be performed to etch the sacrificial layer SFL and a part of the first encapsulation material layer 171L using the photoresist PR as a mask. For example, the third etching process may be a dry etching process.

By this process, the first encapsulation material layer 171L may be formed as a first inorganic layer 171-1, a second inorganic layer 171-2 and a third inorganic layer 171-3 spaced apart from one another, as shown in FIG. 18. The first inorganic layer 171-1 may cover (e.g., completely cover) the first light-emitting element ED11, the second inorganic layer 171-2 may cover (e.g., completely cover) the second light-emitting element ED12, and the third inorganic layer 171-3 may cover (e.g., completely cover) the third light-emitting element ED13.

For example, by this process, the second bank layer 163 of the bank member 160 that is not in contact with the first light-emitting element ED11, the second light-emitting element ED12 and the third light-emitting element ED13 may be exposed.

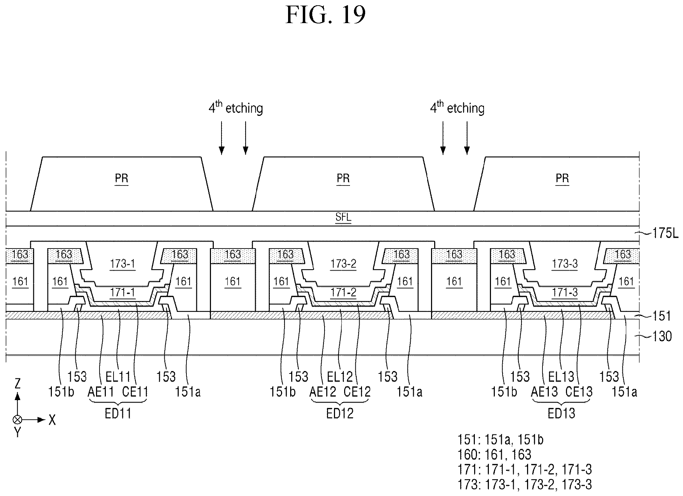

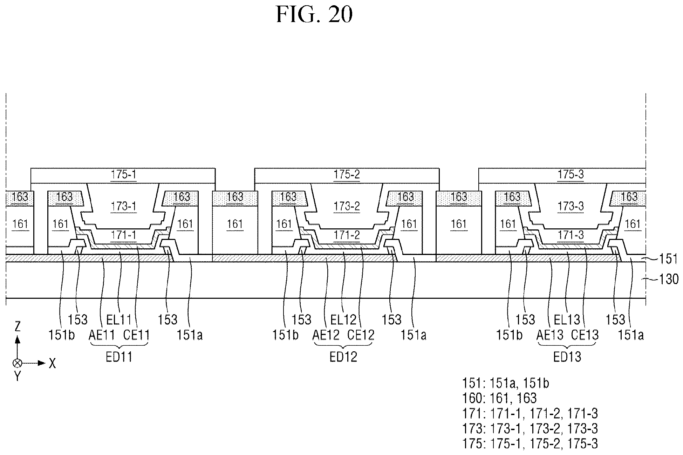

Referring to FIGS. 19 and 20, a third encapsulation material layer 175L and a sacrificial layer SFL may be formed (e.g., entirely formed) on the first encapsulation material layer 171L and the second bank layer 163, and a photoresist PR may be formed on the sacrificial layer SFL such that photoresist PR may overlap each of the first light-emitting element ED11, the second light-emitting element ED12 and the third light-emitting element ED13. According to an embodiment, the sacrificial layer SFL may include the same material as the sacrificial layer SFL described above with reference to FIGS. 10 to 12. For example, a fourth etching process (4^{th} etching) may be performed to etch the sacrificial layer SFL and a part of the third encapsulation material layer 175L using the photoresist PR as a mask. For example, the fourth etching process may be a dry etching process.

By this process, the third encapsulation material layer 175L may be formed in the form of the third encapsulation layer 175 shown in FIG. 20. For example, the third encapsulation layer 175 may be formed as the first inorganic layer 175-1, the second inorganic layer 175-2 and the third inorganic layer 175-3 spaced apart from one another to overlap the first light-emitting element ED11, the second light-emitting element ED12 and the third light-emitting element ED13, respectively.

For example, by this process, the second bank layer 163 of the bank member 160 that is not in contact with the first light-emitting element ED11, the second light-emitting element ED12 and the third light-emitting element ED13 may be exposed.

For example, referring to FIG. 21, a third electrode AE2 may be formed to be in contact with the second bank layer 163 exposed in the previous process. The third electrode AE2 may include a first anode electrode AE21, a second anode electrode AE22, and a third anode electrode AE23. The first anode electrode AE21, the second anode electrode AE22 and the third anode electrode AE23 may be spaced apart from one another on the third encapsulation layer 175.

The first anode electrode AE21 of the third electrode AE2 may be disposed to overlap (e.g., align with) the second emission portion EA1b of the first emission area EA1, the second anode electrode AE22 may be disposed to overlap (e.g., align with) the second emission portion EA2b of the second emission area EA2, and the third anode electrode AE23 may be disposed to overlap (e.g., align with) the second emission portion EA3b of the third emission area EA3.

In this process, each of the first anode electrode AE21, the second anode electrode AE22 and the third anode electrode AE23 is in contact with the second bank layer 163, so that the third electrode AE2 may be connected (e.g., electrically connected) to the second bank layer 163, the first bank layer 161 and the first electrode AE1.

For example, a sacrificial layer SFL may be formed on each of the first anode electrode AE21, the second anode electrode AE22 and the third anode electrode AE23, and a second pixel-defining layer 155 may be formed to partially cover each of the first anode electrode AE21, the second anode electrode AE22 and the third anode electrode AE23. The second pixel-defining layer 155 may separate and insulate the first anode electrode AE21, the second anode electrode AE22 and the third anode electrode AE23 from one another. The sacrificial layer SFL used in this process may include the same material as the sacrificial layer SFL described above with reference to FIGS. 10 to 12.

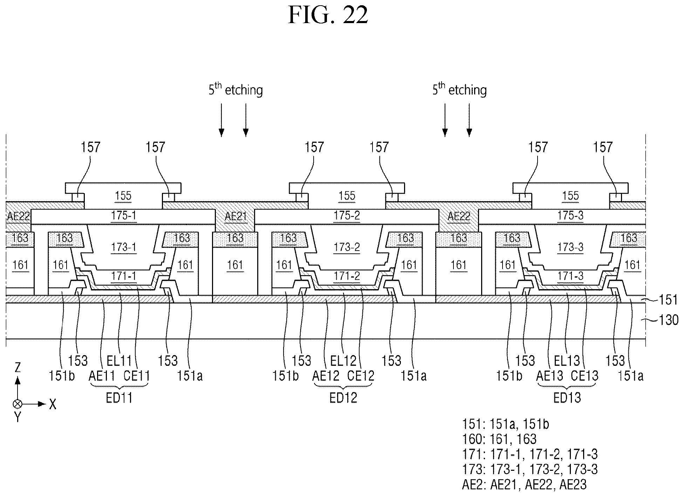

Referring to FIG. 22, a fifth etching (5^{th} etching) process may be performed to remove the sacrificial layer SFL disposed on each of the first anode electrode AE21, the second anode electrode AE22 and the third anode electrode AE23 using the second pixel-defining layer 155 as a mask. As an example, the fifth etching process may be performed as a wet etching process.

By this process, a part of the sacrificial layer SFL disposed on each of the first anode electrode AE21, the second anode electrode AE22 and the third anode electrode AE23 may be removed. A part of the sacrificial layer SFL that remains without being removed may be disposed as a residual pattern layer 157 (or second pattern layer) between the third electrode AE2 and the second pixel-defining layer 155.

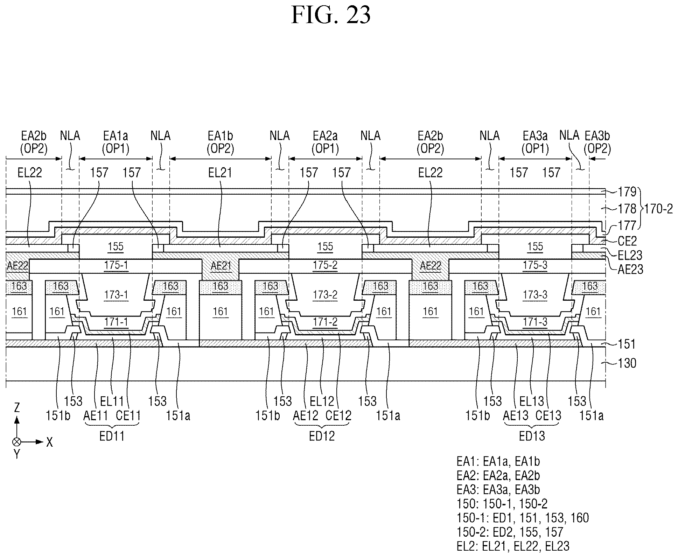

For example, referring to FIG. 23, a common electrode CE2 may be formed to cover (e.g., entirely cover) the second display emissive layer EL2 included in the second display element ED2 and the second pixel-defining layer 155, and a second thin-film encapsulation layer 170-2 may be formed (e.g., entirely formed) on the common electrode CE2. In this manner, the display element layer 150 shown in FIG. 6 may be formed. The first emission portion EA1a of the first emission area EA1, the first emission portion EA2a of the second emission area EA2 and the first emission portion EA3a of the third emission area EA3 may be defined by the first pixel-defining layer 151. The second emission portion EA1b of the first emission area EA1, the second emission portion EA2b of the second emission area EA2 and the second emission portion EA3b of the third emission area EA3 may be defined by the second pixel-defining layer 155.

As shown in FIG. 23, the display device 10 according to an embodiment includes the first light-emitting member 150-1 and the second light-emitting member 150-2 including different emission areas, so that the emission areas may be enlarged while the non-emission area may be reduced. In this manner, the display device 10 according to an embodiment may be implemented to have a high aperture ratio and a high resolution.

Embodiments have been disclosed herein, and although terms are used, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the following claims.

## Claims

1. A display device (10) comprising:
a substrate (110) comprising an emission area comprising:
a first emission portion (EA1a, EA2a, EA3a) and a second emission portion (EA1b, EA2b, EA3b), and
a non-emission area disposed between the first emission portion and the second emission portion;
a first light-emitting member (150-1) comprising a first display element (ED1) disposed on the first emission portion of the substrate (110);
a first thin-film encapsulation layer (170-1) disposed on the first light-emitting member (150-1); and
a second light-emitting member (150-2) disposed on the first thin-film encapsulation layer (170-1) and comprising a second display element (ED2) overlapping the second emission portion,
wherein the first light-emitting member (150-1) comprises:
a first pixel-defining layer (151) defining a first opening (OP1); and
a bank member (160) disposed on the first pixel-defining layer (151) and comprising a first bank layer (161) and a second bank layer (163),
the second display element (ED2) overlaps the first pixel-defining layer (151) and the bank member (160) in a direction perpendicular to an upper surface of the substrate (110), and
the second display element (ED2) is in contact with the second bank layer (163).

2. The display device (10) of claim 1, wherein the first display element (ED1) comprises:
a first electrode;
a first display emissive layer disposed on the first electrode; and
a second electrode disposed on the first display emissive layer, wherein
the first display emissive layer and the second electrode are in contact with a side surface (1c, 3c) of the first bank layer (161) that faces the first emission portion, and
the second electrode is electrically connected to the first bank layer (161).

3. The display device (10) of claim 2, wherein
the second bank layer (163) comprises a tip portion that protrudes toward the first emission portion from the side surface (1c) of the first bank layer (161), and
the side surface (1c) of the first bank layer (161) and the tip portion of the second bank layer (163) form an undercut portion.

4. The display device (10) of claim 2 or 3, wherein
a first pattern layer is disposed between the first electrode and the first pixel-defining layer (151) in the direction perpendicular to the upper surface of the substrate (110) in the non-emission area, and
the first pattern layer is in contact with the first display emissive layer.

5. The display device (10) of any of the preceding claims, wherein the first opening (OP1) defines the first emission portion (EA1a, EA2a, EA3a).

6. The display device (10) of any of the preceding claims, wherein
the first thin-film encapsulation layer (170-1) comprises:
a first encapsulation layer (171, 177) in contact with the first display element and the bank member (160);
a second encapsulation layer (173, 178) including an organic material disposed on the first encapsulation layer (171, 177); and
a third encapsulation layer (175, 179) including an inorganic material disposed on the second encapsulation layer (173, 178), and
the second encapsulation layer (173, 178) is completely surrounded by the first encapsulation layer (171, 177) and the third encapsulation layer (175, 179) in the first emission portion, and/or wherein the second encapsulation layer (173, 178) does not overlap the second emission portion.

7. The display device (10) of any of the preceding claims, wherein
the second light-emitting member (150-2) further comprises a second pixel-defining layer (155) overlapping the first emission portion (EA1a, EA2a, EA3a) and defining a second opening (OP2), and
the second pixel-defining layer (155) overlaps the first display element in the direction perpendicular to the upper surface of the substrate (110), and/or wherein the second display element (ED2) comprises:
a third electrode;
a second display emissive layer disposed on the third electrode; and
a common electrode disposed on the second display emissive layer and the second pixel-defining layer (155).

8. The display device (10) of claim 7, wherein
the third electrode is in contact with the second bank layer (163) in the direction toward the substrate (110), and
the third electrode is electrically connected to the second bank layer (163), the first bank layer (161), and the first electrode, and/or wherein
a second pattern layer is disposed between the third electrode and the second pixel-defining layer (155) in the direction perpendicular to the upper surface of the substrate (110) in the non-emission area, and
the second pattern layer is in contact with the second display emissive layer.

9. The display device (10) of any of claims 7 or 8, wherein the second opening defines the second emission portion, and/or wherein
the first pixel-defining layer (151) has a mesh pattern that completely surrounds the first emission portion in plan view, and
the second pixel-defining layer (155) has a mesh pattern that completely surrounds the second emission portion in plan view.

10. The display device (10) of any of claims 7 to 9, wherein the emission area is larger than the non-emission area in plan view.

11. The display device (10) of any of the preceding claims, wherein
the bank member (160) comprises:
a first portion (160a: 161a, 163a) in contact with the first light-emitting element,
a second portion (160b; 161b, 163b) in contact with the third light-emitting element, and
a third portion (160c; 161c, 163c) in contact with the second light-emitting element, and
the first portion (160a, 161a, 163a), the second portion (160b, 161b, 163b) and the third portion (160c, 161c, 163c) are spaced apart from one another with the first encapsulation layer (171, 177) disposed between the first portion (160a, 161a, 163a), the second portion (160b, 161b, 163b) and the third portion (160c, 161c, 163c), and/or,
wherein the first encapsulation layer (171, 177) comprises:
a first inorganic layer (171-1, 175-1) surrounding the first portion (, 160a, 161a, 163a); and
a second inorganic layer (171-2, 175-2) surrounding the third portion (160c, 161c, 163c), and
the first inorganic layer (171-1, 175-1) and the second inorganic layer (171-2, 175-2) are spaced apart from each other in a direction parallel to an upper surface of the substrate (110) with the second portion (160b, 161b, 163b) disposed between the first inorganic layer (171-1, 175-1) and the second inorganic layer (171-2, 175-2).

12. The display device (10) of claim 11, wherein
the first light-emitting member (150-1) further comprises a first pixel-defining layer (151) disposed between the substrate (110) and the bank member (160),
the first pixel-defining layer (151) comprises:
a first sub-portion in contact with the first portion (151a, 160a, 161a, 163a), and
a second sub-portion in contact with the third portion (160c, 161c, 163c), and
the first sub-portion and the second sub-portion are spaced apart from each other with the second portion (151b, 160b, 161b, 163b) disposed between the first sub-portion and the second sub-portion, and/or wherein
the second light-emitting element comprises an anode electrode, and
the second portion (151b, 160b, 161b, 163b) is in contact with the anode electrode in a direction toward the substrate (110).

13. A method of fabricating a display device (10) of any of the preceding claims, the method comprising:
preparing a substrate (110) comprising:
an emission area comprising a first emission portion and a second emission portion, and
a non-emission area disposed between the first emission portion and the second emission portion;
forming a first electrode disposed on the first emission portion of the substrate (110) and a sacrificial layer disposed on the first electrode, and forming a first pixel-defining material layer (151L) that covers the sacrificial layer and exposes a part of the first electrode;
forming a first bank material layer (161L) covering the first electrode and the first pixel-defining material layer (151L), and a second bank material layer (163L) disposed on the first bank material layer (161L), and removing the first bank material layer (161L) and the second bank material layer (163L) and a part of the first pixel-defining material layer (151L) by an etching process to form first and second holes overlapping the first electrode and spaced apart from each other;
partially etching an inside of the first hole by an etching process to form a first bank layer (161) and a second bank layer (163) having a tip portion protruding from the first bank layer (161) toward the first emission portion, and forming a first pixel-defining layer (151) defining a first opening;
forming a first display emissive layer and a second electrode disposed on the first electrode such that the first display emissive layer and the second electrode are in contact with a side surface (1c, 3c) of the first bank layer (161) in the first emission portion, and forming a first thin-film encapsulation layer (170-1) covering the second electrode, the first bank layer (161) and the second bank layer (163);
removing a part of the first thin-film encapsulation layer (170-1) by an etching process in the second emission portion to expose a part of the second bank layer (163) in the second emission portion;
forming a third electrode disposed on the second bank layer (163) and the first thin-film encapsulation layer (170-1) and a sacrificial layer disposed on the third electrode in the second emission portion, and a second pixel-defining layer (155) cover a part of the sacrificial layer and defining a second opening in the first emission portion;
removing the sacrificial layer disposed on the third electrode by an etching process using the second pixel-defining layer (155) as a mask, forming a second display emissive layer disposed on the third electrode, and then a common electrode entirely covering the second display emissive layer and the second pixel-defining layer (155); and
forming a second thin-film encapsulation layer (170-2) disposed on the common electrode,
wherein the forming of the third electrode comprises disposing the third electrode to contact the second bank layer (163).

14. The method of claim 13, wherein
the first pixel-defining layer (151) overlaps the second display emissive layer in a direction perpendicular to the upper surface of the substrate (110), and
the second pixel-defining layer (155) overlaps the first display emissive layer in the direction perpendicular to the upper surface of the substrate (110).
